(19)

**Europäisches Patentamt**
**European Patent Office**
**Office européen des brevets**

(11) **EP 4 712 080 A1**

(12) **EUROPEAN PATENT APPLICATION**
published in accordance with Art. 153(4) EPC

(43) Date of publication:
**18.03.2026 Bulletin 2026/12**

(21) Application number: **24924253.8**

(22) Date of filing: **25.07.2024**

(51) International Patent Classification (IPC):
***G11C 16/26*** *(2006.01)*

(86) International application number:
**PCT/CN2024/107652**

(87) International publication number:
**WO 2026/020433 (29.01.2026 Gazette 2026/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Yangtze Memory Technologies Co.,
Ltd.**
**Wuhan, Hubei 430074 (CN)**

(72) Inventors:
• **TANG, Xingwei**
**Wuhan, Hubei 430074 (CN)**
• **XIE, Chaofan**
**Wuhan, Hubei 430074 (CN)**
• **LUO, Wen**
**Wuhan, Hubei 430074 (CN)**

(74) Representative: **Gramm, Lins & Partner
Patent- und Rechtsanwälte PartGmbB
Freundallee 13a
30173 Hannover (DE)**

(54) **MEMORY SYSTEM AND OPERATION METHOD THEREFOR, MEMORY CONTROLLER, AND
STORAGE MEDIUM**

(57) The examples of the present disclosure discloses a memory system and an operation method thereof, a memory controller and a storage medium, and the memory system comprises a memory device comprising a plurality of word lines, a plurality of storage units coupled to the same word line form at least one physical page; the memory controller is configured to: obtain a first parameter of a first physical page of the plurality of physical pages in a process of performing a read scrub operation, wherein the first parameter is a parameter in a preset model for generating a target reference voltage, and the target reference voltage is used as a read voltage of the physical page when the read operation is performed; the plurality of physical pages comprise a first physical page and a second physical page, the first physical page is a target physical page of the read scrub operation, and the second physical page is another physical page other than the first physical page; generate a first parameter of the second physical page according to the first parameter of the first physical page in combination with a location relationship of the second physical page and the first physical page; and store the first parameter of the first physical page and the first parameter of the second physical page.

When performing a read scrub operation, obtain a first parameter of a first physical page of a plurality of physical pages, wherein the first parameter is a parameter in a preset model for generating a target reference voltage, and the target reference voltage is used as a read voltage of the physical page when performing a read operation, and wherein the plurality of physical pages includes the first physical page and a second physical page, the first physical page is a target physical page of the read scrub operation in the plurality of physical pages, and the second physical page is another physical page other than the first physical page of the plurality of physical pages — S10

Generate a first parameter of the second physical page according to the first parameter of the first physical page in combination with a location relationship between the second physical page and the first physical page — S20

Store the first parameter of the first physical page and the first parameter of the second physical page — S30

Fig.6

EP 4 712 080 A1

**Description**

**TECHNICAL FIELD**

The present disclosure relates to a memory system, an operating method thereof, a memory controller and a storage medium.

**BACKGROUND**

With the development of science and technology, the market size of the integrated circuit industry is getting larger and larger, and the process and technology of the nonvolatile memory device in the whole integrated circuit industry have been developed in recent years, and the application of NAND-type memory is particularly extensive. NAND-type memory implements the function of data storage by trapping and storing charge in the gate dielectric layer of the memory cells contained therein. However, with the increase of the use time, the charge stored in the memory cell will change with the increase of the use time, the repeated read operation, the cross temperature, etc., thus affecting the correctness of the reading of the stored data of the memory cell.

**SUMMARY**

According to a first aspect, an example of the present disclosure provides a memory system, including: a memory device including a plurality of word lines; each word line is coupled to a plurality of memory cells, and a plurality of memory cells coupled to a same word line form at least one physical page; a memory controller coupled to the memory device and configured to: in a process of performing a read scrub operation, obtain a first parameter of a first physical page of a plurality of physical pages, the first parameter is a parameter in a preset model for generating a target reference voltage, and the target reference voltage is used as a read voltage of the physical page when performing a read operation; the plurality of physical pages includes the first physical page and a second physical page, the first physical page is a target physical page of the read scrub operation in the plurality of physical pages, and the second physical page is another physical page other than the first physical page of the plurality of physical pages; generate a first parameter of the second physical page according to the first parameter of the first physical page in combination with a location relationship between the second physical page and the first physical page; and store the first parameter of the first physical page and the first parameter of the second physical page.

According to a second aspect, an example of the present disclosure provides a memory controller coupled to at least one memory device, the memory device includes a plurality of word lines; each word line is coupled to a plurality of memory cells, and a plurality of memory cells coupled to a same word line form at least one physical page; the memory controller includes an interface, a buffer, and a control unit; wherein the control unit is configured to: obtain a first parameter of a first physical page of a plurality of physical pages according to data fed back by the memory device, the first parameter is a parameter in a preset model for generating a target reference voltage, and the target reference voltage is used as a read voltage of the physical page when performing a read operation; the plurality of physical pages include the first physical page and a second physical page, the first physical page is a target physical page of the read scrub operation in the plurality of physical pages, and the second physical page is another physical page other than the first physical page of the plurality of physical pages; generate a first parameter of the second physical page according to the first parameter of the first physical page in combination with a location relationship between the second physical page and the first physical page; and store, by the buffer, the first parameter of the first physical page and the first parameter of the second physical page.

According to a third aspect, an example of the present disclosure provides a method for operating a memory system, the operation method includes: in a process of performing a read scrub operation, obtaining a first parameter of a first physical page of a plurality of physical pages, the first parameter is a parameter in a preset model for generating the target reference voltage, and the target reference voltage is used as a read voltage of the physical page when performing a read operation; the memory system includes at least one memory device, and the memory device includes a plurality of word lines; each word line is coupled to a plurality of memory cells, and the plurality of memory cells coupled to a same word line form at least one physical page; the plurality of physical pages include the first physical page and a second physical page, the first physical page is at least one physical page performing the read scrub operation, and the second physical page is another physical page other than the first physical page of the plurality of physical pages; generating a first parameter of the second physical page according to the first parameter of the first physical page in combination with a location relationship between the second physical page and the first physical page; and storing the first parameter of the first physical page and the first parameter of the second physical page.

According to a fourth aspect, an example of the present disclosure provides a storage medium, the storage medium stores an executable instruction, and when the executable instruction is executed, the step of the operation method according to any one of the third aspect may be implemented.

## BRIEF DESCRIPTION OF DRAWINGS

In the drawings, like reference numbers refer to like or similar parts or elements throughout the several drawings unless otherwise specified. These drawings are not necessarily drawn to scale. It should be understood that these drawings depict only some implementations disclosed in accordance with the present disclosure and should not be considered as limiting the scope of the present disclosure.

FIG. 1 is a schematic diagram of an exemplary system with a memory system according to an example of the present disclosure;

FIG. 2A is a schematic diagram of an exemplary memory card with a memory system according to an example of the present disclosure;

FIG. 2B is a schematic diagram of an exemplary solid state drive with a memory system according to an example of the present disclosure;

FIG. 3 is a schematic diagram of an exemplary memory including a peripheral circuit according to an example of the present disclosure;

FIG. 4 is a schematic cross-sectional view of a memory cell array including a NAND-type memory string according to an example of the present disclosure;

FIG. 5 is a schematic diagram of an exemplary memory device including a memory cell array and a peripheral circuit according to an example of the present disclosure;

FIG. 6 is a schematic flowchart of an operation method a peripheral circuit of a memory device configured to execute according to an example of the present disclosure;

FIG. 7A is a schematic diagram of a threshold voltage distribution corresponding to a memory cell including 2 memory bits according to an example of the present disclosure;

FIG. 7B is a schematic diagram of a threshold voltage distribution corresponding to a memory cell including 3 memory bits according to an example of the present disclosure;

FIG. 7C is a schematic diagram of a threshold voltage distribution corresponding to a memory cell including 4 memory bits according to an example of the present disclosure;

FIG. 8 is a schematic diagram of a threshold voltage distribution of a memory cell when a first result is obtained according to an example of the present disclosure;

FIG. 9 is a schematic diagram of a first parameter of different physical pages as shown in FIG. 7B under a fourth level of read voltage L4 according to an example of the present disclosure;

FIG. 10 is a schematic diagram of a first parameter of different physical pages as shown in FIG. 7B under a seventh level of read voltage L7 according to an example of the present disclosure;

FIG. 11 is a schematic diagram of a preset model according to an example of the present disclosure;

FIG. 12 is a schematic diagram of determining a first preset interval according to an example of the present disclosure;

FIG. 13 is a first schematic diagram of obtaining a reference read voltage according to an example of the present disclosure;

FIG. 14 is a second schematic diagram of obtaining a reference read voltage according to an example of the present disclosure;

FIG. 15 is a third schematic diagram of obtaining a reference read voltage according to an example of the present disclosure;

FIG. 16 is a fourth schematic diagram of obtaining a reference read voltage according to an example of the present disclosure;

FIG. 17 is a schematic diagram of a confirmation result of a target reference voltage of a second level of read voltage L2 as shown in FIG. 7B according to an example of the present disclosure;

FIG. 18 is a schematic diagram of a confirmation result of a target reference voltage of a fourth level of read voltage L4 as shown in FIG. 7B according to an example of the present disclosure;

FIG. 19 is a first schematic flowchart of a method for operating a memory system according to an example of the present disclosure;

FIG. 20 is a schematic diagram of an exemplary composition structure with a memory system according to an example of the present disclosure;

FIG. 21 is a block diagram of a memory system according to an example of the present disclosure;

FIG. 22 is a timing diagram of an exemplary startup single-level read mode operation according to the present disclosure;

FIG. 23 is a timing diagram of performing a read scrub operation according to an example of the present disclosure;

FIG. 24 is a second flowchart of a method for operating a memory system according to an example of the present disclosure;

FIG. 25 is a schematic diagram of a composition structure of a storage medium according to an example of the present disclosure.

## DETAILED DESCRIPTION

Exemplary implementations disclosed in the present disclosure will be described in more detail below with reference to the accompanying drawings. Although exemplary implementations of the present disclosure are shown in the accompanying drawings, it is to be understood that the present disclosure may be implemented in various forms and should not be limited to the implementations set forth herein. Rather, these examples are provided so that the present disclosure can be more thoroughly understood and the scope disclosed in the present disclosure can be fully conveyed to those skilled in the art.

In the following description, numerous details are given in order to provide a more thorough understanding of the present disclosure. However, it will be apparent to one skilled in the art that the present disclosure may be practiced without one or more of these details. In other examples, in order to avoid confusion with the present disclosure, some technical features known in the art are not described; that is, not all features of the actual example are described here, and well-known functions and structures are not described in detail.

In addition, the drawings are merely schematic illustrations of the present disclosure, and are not necessarily drawn to scale. Like reference numerals in the drawings refer to the same or similar parts, and repeated description thereof will be omitted. Some of the block diagrams shown in the drawings are functional entities and do not necessarily have to correspond to physically or logically separate entities. These functional entities may be implemented in software form, or implemented in one or more hardware modules or integrated circuits, or implemented in different networks and / or processor devices and / or microcontroller devices.

The flowchart shown in the drawings is merely exemplary and not necessarily all steps. For example, some steps may be further decomposed, and some steps may be combined or partially combined, so the actual execution sequence may be changed according to actual conditions.

A term used herein is for the purpose of describing a particular example only and is not to be considered as limitation of the present disclosure. As used herein, the singular forms "a", "an" and "said/the" are intended to include the plural forms as well, unless the context clearly dictates otherwise. It should also be understood that the terms "consists of" and/or "comprising", when used in this description, identify the presence of stated features, integers, steps, operations, elements and/or parts, but do not exclude the presence of one or more other features, integers, steps, operations, elements, parts and/or groups. As used herein, the term "and/or" includes any and all combinations of the associated listed items.

Memory devices in examples of the present disclosure include but are not limited to a three-dimensional NAND-type memory, and for ease of understanding, a three-dimensional NAND-type memory is used as an example for illustration.

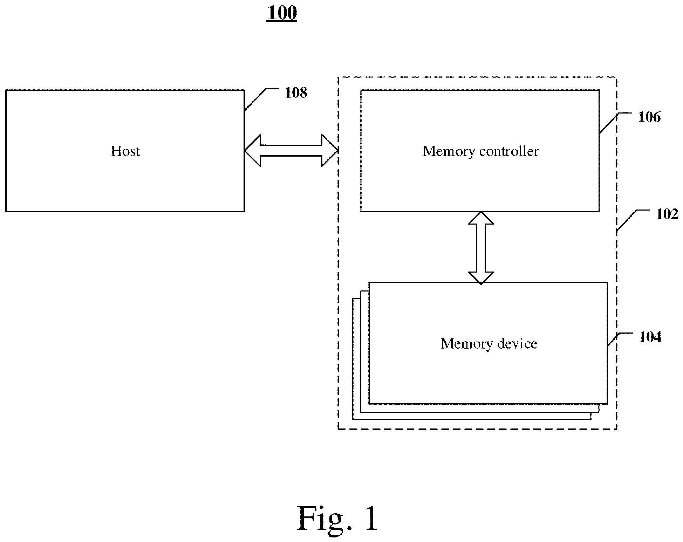

FIG.1 illustrates a block diagram of an exemplary system 100 with memory devices in accordance with some aspects of the present disclosure. The system 100 may be a mobile phone, a desktop computer, a laptop computer, a tablet, a vehicle computer, a gaming console, a printer, a positioning device, a wearable electronic device, a smart sensor, a Virtual Reality (VR) device, an Augment Reality (AR) device, or any other suitable electronic devices having memory therein. As shown in in FIG.1, system 100 may include a host 108 and a memory system 102, and the memory system 102 has one or more memory devices 104 and a memory controller 106. The host 108 may be a processor of an electronic device (e.g., a Central Processing Unit (CPU)) or a System of Chip (SoC) (e.g., an Application Processor (AP)). Host 108 may be configured to send data to or receive data from memory device 104.

According to some implementations, memory controller 106 is coupled to memory device 104 and host 108 and is configured to control memory device 104. Memory controller 106 may manage data stored in memory device 104 and communicate with host 108. In some implementations, the memory controller 106 is designed to operate in low duty cycle environments, e.g., Secure Digital (SD) card, Compact Flash (CF) card, Universal Serial Bus (USB) flash drive, or other media for use in electronic devices such as personal computer, digital camera, mobile phone, etc.

In some implementations, the memory controller 106 is designed to operate in high duty cycle environment Solid State Drive (SSD) or Embedded Multi Media Card (eMMC), where SSD or eMMC is used as data memory for mobile devices such as smartphone, tablet computer, laptop computer, and enterprise storage array.

Memory controller 106 may be configured to control operations of memory device 104, e.g., read, erase and program operations. Memory controller 106 may also be configured to manage various functions related to data stored or to be stored in memory device 104, including but not limited to bad block management, garbage collection, logical-to-physical address translation, wear leveling, etc. In some implementations, memory controller 106 is also configured to process error correction code related to data read from or written to memory device 104.

The memory controller 106 may also perform any other suitable functions, e.g., formatting the memory device 104. Memory controller 106 may communicate with external devices (e.g., host 108) according to a particular communication protocol. For example, the memory controller 106 may communicate with external devices through at least one of various interface protocols, such as USB protocol, MMC protocol, Peripheral Component Interconnection (PCI) protocol, PCI Express (PCI-E) protocol, Advanced Technology Attachment (ATA) protocol, Serial ATA protocol, Parallel ATA protocol, Small Computer Small Interface (SCSI) protocol, Enhanced Small Disk Interface (ESDI) protocol, Integrated Drive Electronics (IDE) protocol, Firewire protocol, etc.

The memory controller 106 and one or more memory device 104 may be integrated into various types of storage devices, e.g., included in the same package (e.g., Universal Flash Storage (UFS) package or eMMC package). That is, memory system 102 may be implemented and packaged into different types of end electronic products.

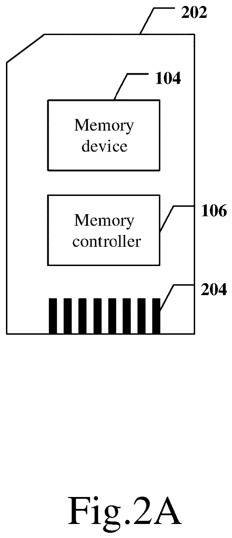

In one example as shown in FIG 2A, memory controller 106 and a single memory device 104 may be integrated into a memory card 202. Memory card 202 may include a PC card (PCMCIA, personal computer memory card international association), a CF card, a smart media (SM) card, a memory stick, a mulinstant of timedia card (MMC, RS-MMC, MMCmicro), an SD card (SD, miniSD, microSD, SDHC), a UFS, etc. Memory card 202 may further include a memory card connector 24 coupling memory card 202 with a host (e.g., host 108 in FIG 1).

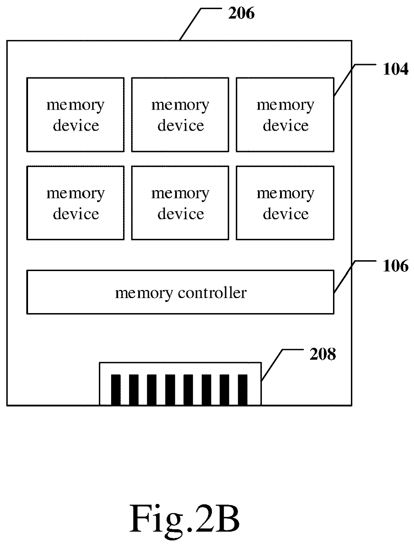

In another example as shown in FIG.2B, memory controller 106 and multiple memory devices 104 may be integrated into a SSD 206. The SSD 206 may further include an SSD connector 208 coupling the SSD 206 with a host (e.g., host 108 in FIG.1). In some implementations, the storage capacity and/or operating speed of the SSD 206 is greater than the storage capacity and/or operating speed of memory card 202.

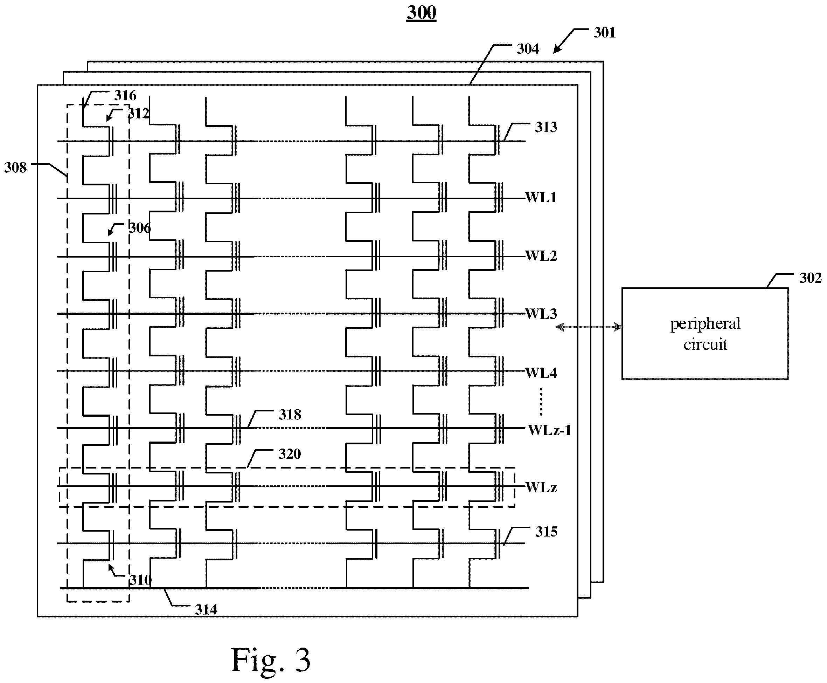

FIG.3 illustrates a schematic circuit diagram of an exemplary memory device 300 including peripheral circuitry according to some aspects of the present disclosure. Memory device 300 may be an example of memory device 104 in FIG.1. The memory device 300 may include a memory cell array 301 and a peripheral circuit 302 coupled to the memory cell array 301. Taking memory cell array 301 being a three-dimensional NAND-type memory cell array as an example for illustration, where memory cells 306 are NAND-type memory cells, and memory cells 306 are provided in the form of an array of memory strings 308, each memory string 308 extending vertically over a substrate (not shown). In some implementations, each memory string 308 includes multiple memory cells 306 coupled in series and stacked vertically. Each memory cell 306 may retain a continuous analog value, e.g., voltage or charge, depending on the number of electrons trapped within the region of the memory cell 306. Each memory cell 306 may be a "floating gate" type memory cell including a floating gate transistor, or a "charge trap" type memory cell including a charge trap transistor.

In some implementations, each memory cell 306 is a Single-level Cell (SLC) that has two possible storage states and may thus store one bit of data. For example, a first storage state of "0" may correspond to a first voltage range, and a second storage state of "1" may correspond to a second voltage range. In some implementations, each memory cell 306 is a Multi-Level Cell (MLC) capable of storing more than a single bit of data in more than four storage states. For example, an MLC may store two bits per cell (also known as a Double-Level Cell), three bits per cell (also known as a Trinary-Level Cell (TLC)), four bits per cell (also known as a Quad-Level Cell (QLC)), five bits per cell (also known as a Penta-level cell (PLC)), or more than five bits per cell. Each MLC can be programmed to assume a range of possible nominal storage values. In one example, if each MLC stores two bits of data, the MLC can be programmed to assume one of three possible program levels from the erased state through writing one of three possible nominal storage values into the cell, a fourth nominal storage value may be used for the erase state.

It is to be noted that the storage state mentioned here is also the storage state of the memory cell mentioned in the present disclosure. Different memory cells have different numbers of storage states. e.g., a SLC type memory cell has two storage states (i.e., two storage states), where the two storage states include a program state and an erase state. As another example, an MLC type memory cell has four storage states, where the four storage states include one erase state and three program states. As yet another example, a TLC type memory cell has eight storage states, where the eight storage states include one erase state and seven program states. In some implementation, the QLC type memory cell has sixteen storage states, where the sixteen storage states include one erase state and fifteen program states.

As shown in FIG.3, each memory string 308 may include a bottom select gate (BSG) 310 (also referred to as a source side select gate) at its source terminal and a top select gate (TSG) 312 (also referred to as a drain side select gate) at its drain terminal. BSG 310 and TSG 312 may be configured to activate the selected memory cell string 308 during read operation and program operation. In some implementations, the sources of memory strings 308 in a same memory block 304 are coupled through a same source line (SL) 314 (e.g., a common SL). In other words, according to some implementations, all memory strings 308 in a same memory block 304 have an array common source (ACS). According to some implementations, TSG 312 of each memory string 308 is coupled to a corresponding bit line (BL) 316 from which data may be read or written via an output bus (not shown). In some implementations, each memory string 308 is configured to be selected or deselected through applying a select voltage (e.g., above the threshold voltage of a transistor with a TSG 312 ) or a deselect voltage (e.g., 0V) to the corresponding TSG 312 via one or more TSG lines 313 and/or applying a select voltage (e.g., above the threshold voltage of a transistor with a BSG 310) or a deselect voltage (e.g., 0V) to the corresponding BSG 310 via one or more BSG lines 315.

As also shown in FIG.3, a memory string 308 may be organized into multiple memory blocks 304 each of which may have a common source line 314 (e.g., coupled to ground). In some implementations, each memory block 304 is the basic data unit for an erase operation, i.e., all memory cells 306 on the same memory block 304 are erased simultaneously.

To erase the memory cell 306 in the selected memory block 304, the source line 314 coupled to the selected memory block 304 and to the unselected memory blocks 304 in the same plane as the selected memory block 304 may be biased with an erase voltage (Vers) (e.g., a high positive voltage (e.g., 20V or higher)). It is to be understood that, in some examples, erase operations may be performed at the half-memory block level, at the quarter-memory block level, or at a level with any suitable number of memory blocks or any suitable fraction of memory blocks. The memory cells 306 of adjacent memory strings 308 may be coupled through a word line 318 that selects which row of memory cells 306 is affected by read and program operations. In some examples, each memory block may be coupled to a plurality of word lines, and a plurality of memory cells coupled to each word line form one or more physical pages, wherein a number of physical pages is related to a number of memory bits included in the memory cell, and for example, a plurality of SLCs coupled to each word line form a physical page, a plurality of MLCs coupled to each word line form two physical pages, and a plurality of TLCs coupled to each word line form three physical pages. In some examples, as shown in FIG. 3, a plurality of memory cells coupled to each word line (with the number of memory bits of one bit) form a physical page 320. Referring to FIG.3, each memory cell 306 of the multiple memory cells is coupled to a corresponding word line 318, and each memory string 308 is coupled to a corresponding bit line 316 through a corresponding select transistor (e.g., top select transistor (TSG) 312).

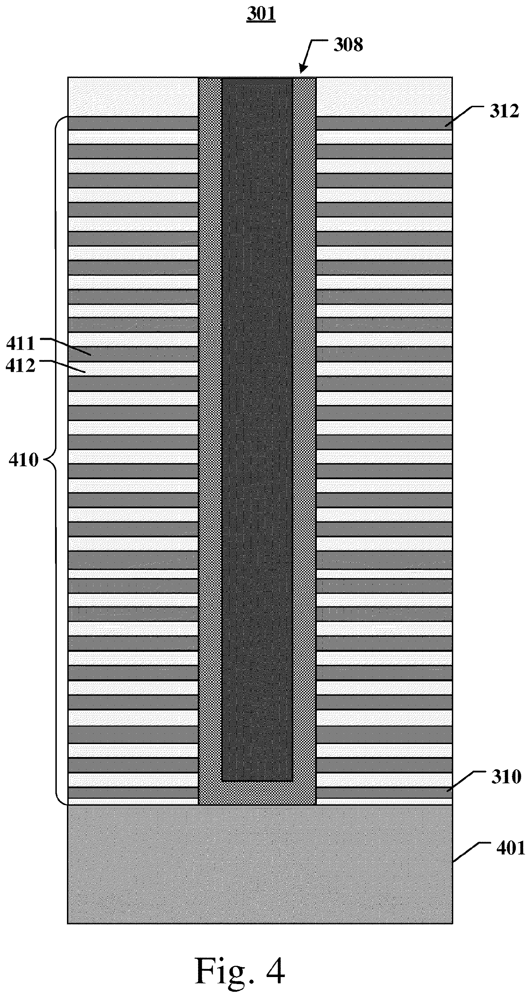

FIG.4 illustrates a schematic cross-sectional view of an exemplary memory cell array 301 including memory strings 308, e.g., NAND, according to some aspects of the present disclosure. As shown in FIG.4, the NAND memory cell array 301 may include a stacked structure 410, the stacked structure 410 includes multiple gate layers 411 and multiple insulating layers 412 alternately stacked in sequence, and the channel structure vertically penetrating through the gate layers 411 and the insulating layers 412, wherein the channel structure is coupled to each gate layer to form a memory cell, and the channel structure is coupled to multiple gate layers in the stacked structure 410 to form the memory string 308. Gate layers 411 and the insulating layers 412 may be stacked alternately, and two adjacent gate layers 411 are separated by an insulating layer 412.

A constituent material of the gate layer 411 may include a conductive material. Conductive materials include, but are not limited to, tungsten (W), cobalt (Co), copper (Cu), aluminum (Al), polysilicon, doped silicon, silicide, or any combination thereof. In some examples, each gate layer 411 includes a metal layer, e.g., a tungsten layer. In some examples, each gate layer 411 includes a doped polysilicon layer. Each gate layer 411 may include a control gate surrounding a memory cell. A gate layer 411 at the top of a stacked structure 410 may extend laterally as a top select gate line, a gate layer 411 at the bottom of a stacked structure 410 may extend laterally as a bottom select gate line, and a gate layer 411 extending laterally between a top select gate line and a bottom select gate line may serve as a word line layer.

In some examples, a stacked structure 410 may be disposed on a substrate 401. The substrate 401 may include silicon (e.g., monocrystalline silicon), silicon germanium (SiGe), gallium arsenide (GaAs), germanium (Ge), silicon-on-insulator (SOI), germanium-on-insulator (GOI), or any other appropriate material.

In some examples, a memory string 308 includes a channel structure extending vertically through stacked structure 410. In some implementations, a channel structure includes a channel hole filled with semiconductor material(s) (e.g., as a semiconductor channel) and dielectric material(s) (e.g., as a memory film). In some implementations, a semiconductor channel includes silicon, e.g., polysilicon. In some implementations, a memory film is a composite dielectric layer including a tunneling layer, a storage layer (also referred to as a "charge trapping/storage layer"), and a blocking layer. A channel structure may have a cylindrical shape (e.g., a pillar shape). According to some implementations, a semiconductor channel, a tunneling layer, a storage layer and a blocking layer are radially arranged in this order from the center of the pillar toward the outer surface of the pillar. A tunneling layer may include silicon oxide, silicon oxynitride, or any combination thereof. A storage layer may include silicon nitride, silicon oxynitride, or any combination thereof. A blocking layer may include silicon oxide, silicon oxynitride, a high-k (high-k) dielectric, or any combination thereof. In an example, a memory film may include a composite layer of silicon oxide/silicon oxynitride/silicon oxide (ONO).

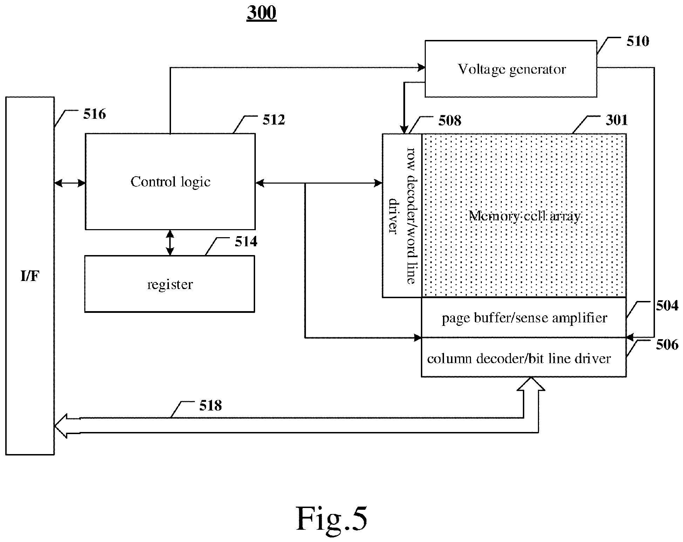

Referring back to FIG.3, the peripheral circuit 302 may be coupled to the memory cell array 301 through bit line 316, word line 318, source line 314, BSG line 315, and TSG line 313. The peripheral circuit 302 may include any suitable analog, digital, and mixed-signal circuitry for facilitating operation of the memory cell array 301 through applying a voltage signal and/or a current signal to and sensing voltage signal and/or current signal from each target memory cell 306 via bit line 316, word line 318, source line 314, BSG line 315, and TSG line 313. The peripheral circuit 302 may include various types of peripheral circuits formed with metal-oxide-semiconductor (MOS) technology. For example, FIG.5 illustrates some exemplary peripheral circuits, the peripheral circuit includes page buffer/sense amplifier 504, column decoder/bit line driver 506, row decoder/word line driver 508, voltage generator 510, control logic 512, register 514, interface 516 and data bus 518. It is to be understood that in some examples, additional peripheral circuits not shown in FIG.5 may also be included.

The page buffer/sense amplifier 504 may be configured to read data from and program (write) data to the memory cell array 301 according to control signals from the control logic 512. In one example, the page buffer/sense amplifier 504 may store program data (written data) to be programmed into the memory cell array 301. In another example, the page buffer/sense amplifier 504 may perform a program verify operation to ensure that data has been correctly programmed into memory cell 306 coupled to selected word line 318. In yet another example, the page buffer/sense amplifier 504 may also sense a low power signal from bit line 316 representing a data bit stored in memory cell 306 and amplify a small voltage swing to a recognizable logic level during a read operation. The column decoder/bit line driver 506 may be configured to be controlled by control logic 512 and to select one or more memory strings 308 through applying a bit line voltage generated from voltage generator 510.

The row decoder/word line driver 508 may be configured to be controlled by control logic 512 and to select/deselect memory block 304 of memory cell array 301 and to select/deselect word line 318 of memory block 304. The row decoder/word line driver 508 may also be configured to drive word line 318 with a word line voltage generated from voltage generator 510. In some implementations, the row decoder/word line driver 508 may also select/deselect and drive the BSG line 315 and the TSG line 313. As described in detail below, the row decoder/word line driver 508 is configured to perform program operations on the memory cells 306 coupled to the selected word line 318. The voltage generator 510 may be configured to be controlled by the control logic 512, and generate word line voltage (e.g., read voltage, program voltage, pass voltage, channel boost voltage, verify voltage, etc.), bit line voltage and source line voltage to be supplied to the memory cell array 301.

The control logic 512 may be coupled to each of other units of the peripheral circuit described above, and configured to control operations of each of the other units of the peripheral circuit. The register 514 may be coupled to the control logic 512 and include status register, command register and address register for storing status information, command operation code (OP code) and command address for controlling operations of each of the peripheral circuits. The interface 516 may be coupled to control logic 512 and act as a control buffer to buffer and relay control commands received from a host (not shown) to control logic 512 and to buffer and relay status information received from the control logic 512 to the host. Interface 516 may also be coupled to column decoder/bit line driver 506 via data bus 518 and act as a data I/O interface and data buffer to buffer and relay data to/from memory cell array 301.

The basic principle of the 3D NAND-type memory is a process in which carriers (electrons or holes) inject a certain amount of charge into the memory cell across the charge barrier to complete data writing, and then the stored data can be read according to the threshold voltage when the memory cell is turned on. Therefore, in order to read correct data, an error correction algorithm with strong error correction capability and high efficiency is usually introduced during data read.

However, with the increase of the use time, the charge stored in the memory cell will change with the increase of the use time, the repeated read operation, the cross temperature, etc., thus affecting the correctness of data read. When the threshold voltage is shifted up or down more obvious, when the original read voltage is used to read the data of the memory cell, the possibility that the read error occurs is very large, and when the read error exceeds the error correction capability, resulting in the failure of the data read of the memory cell.

In some examples, read scrub operation is widely used in consumer-level SSDs and enterprise-level SSDs to maintain the integrity and reliability of stored data by regular inspection and error correction mechanisms. Where the consumer-level SSD is mainly used for consumer products such as personal computers and mobile devices, and requires the characteristics of high speed, stability, light weight and the like. The enterprise-level SSD is mainly used in high-load scenarios such as data centers and servers, and requires the characteristics of high reliability, high performance, high capacity and the like, for example, a large amount of enterprise-level data is stored in the data center, and the server usually needs to process a large amount of real-time data, so that it have extremely high requirements for the integrity and the security of the data, and the read scrub is an important means of ensuring the data integrity and reliability of the enterprise-level SSD, especially in a server and a data center scenario. By periodically detecting and verifying the data, discovering and correcting the potential errors, high availability and security of the memory system are ensured.

Next, the process of read scrub operation is described as an example.

In some examples, during the operation of performing the read scrub on a memory block, if the fail bit count (FBC) of the data of the memory cell of the obtained physical page is less than or equal to the first preset threshold, it indicates that the integrity and reliability of the data of the memory cell in the memory block are not affected, and the read scrub operation may continue to be performed on other memory blocks.

In some examples, during the read scrub operation, if the fail bit count of the data of the memory cell of the obtained physical page exceeds the first preset threshold, the data of the memory cell of the corresponding physical page needs to be corrected, and then data migration (also referred to as error correction rewriting) is performed, which is equivalent to performing the refresh operation on the data.

In some implementations, in performing the read scrub operation, when the fail bit count of the data of the memory cell of the obtained physical page exceeds a first preset threshold, a read retry may be triggered to successfully read correct data through multiple attempts. Generally, the read retry may be performed by querying a retry table provided by a manufacturer. The essence of the read retry is an error correction mechanism, in which the retry table may provide a reference voltage for reading data, each memory cell is read again by querying the retry table and attempting to use the read voltage which deviate from the normal threshold voltage, in the meantime error correction is performed by using the error correction algorithm, in an attempt to correctly read the data. If the read error data is corrected, stop querying the retry table. If the data that cannot be read is not corrected, querying the retry table until the entire retry table is traversed.

In the above read retry operation, because the retry table needs to be queried one by one, the number of failed trials will be increased, and the time consumed is relatively long. In addition, the retry table provided by the manufacturer is only the reference value in some environments, and the real time usage scenarios are diverse, then many scenarios cannot be covered by the retry table provided by the manufacturer, and the data cannot be corrected even by traversing the retry table, as a result, large amount of time for processing commands will be wasted. In summary, by repeatedly polling the retry table for read retry, it takes a long time and affects the response time of subsequent commands, thereby affecting the performance of the device.

In other implementations, during the read scrub operation, when the fail bit count of the data of the memory cell of the obtained physical page exceeds the second preset threshold, the garbage collection (GC) operation is triggered, that is, the memory block where the corresponding physical page is located is marked as a bad block, the valid data in the memory block where the corresponding physical page is located is copied to a new memory block, and then the bad block is erased to release the memory space. It may be understood that if the fail bit count of the data of the memory cell of the obtained physical page exceeds the second preset threshold, it indicates that the fail bit count of the data of the memory cell exceeds the maximum error correction capability of the system or the invalid data in the memory block where the corresponding physical page is located reaches a criterion for erasure.

Here, the first preset threshold is less than the second preset threshold, where the first preset threshold may be understood as the early warning value for error correction of the data of the memory cell, to ensure that the integrity and reliability of the data and prevent further expansion of the error or losing data, which may ensure that the read retry operation or the error correction rewriting are performed when the errors in data have not yet resulted in serious impact. The second preset threshold may be understood as an upper limit of an error-correctable range of the data of the memory cell.

Although the read scrub operation is an important means of maintaining the integrity and reliability of the stored data, the read retry operation triggered in the read scrub operation affects the efficiency of the read scrub, consumes additional system resources and time. In addition, the error correction rewriting operation or the garbage collection operation triggered in the read scrub operation increases the write amplification (WA) effect and affects the system performance.

Based on one or more of the foregoing problems, according to the first aspect, an example of the present disclosure provides a memory system.

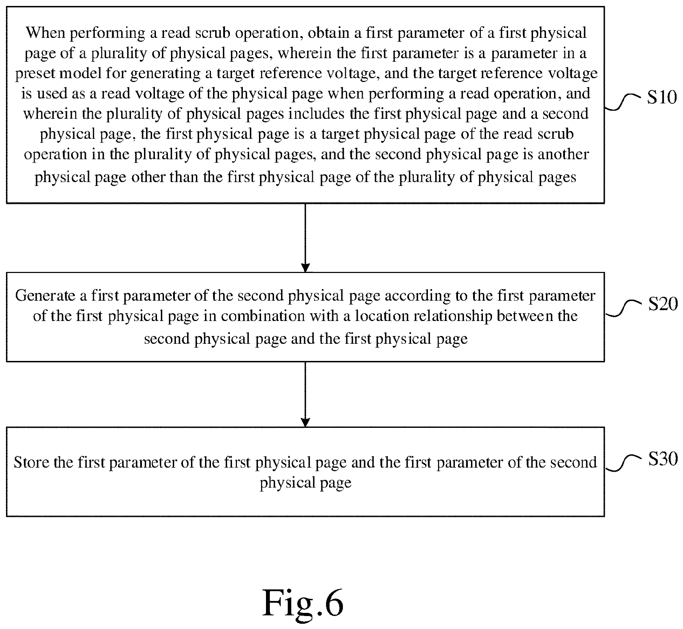

As shown in FIG. 6, the memory system includes: a memory device including a plurality of word lines; each word line is coupled to a plurality of memory cells, and the plurality of memory cells coupled to a same word line form at least one physical page.

A memory controller coupled to the memory device and configured to perform the following steps:

Step S10: in a process of performing a read scrub operation, obtain a first parameter of a first physical page of a plurality of physical pages, the first parameter is a parameter in a preset model for generating a target reference voltage, and the target reference voltage is used as a read voltage of the physical page when performing a read operation; the plurality of physical pages includes a first physical page and a second physical page, the first physical page is a target physical page of a read scrub operation in the plurality of physical pages, and the second physical page is another physical page other than the first physical page of the plurality of physical pages;

Step S20: Generate a first parameter of the second physical page according to the first parameter of the first physical page in combination with a location relationship between the second physical page and the first physical page.

Step S30: Store the first parameter of the first physical page and the first parameter of the second physical page.

Here, the structure of the memory device is referred to the foregoing FIG. 3, and details are not described herein again.

In some examples, the memory device includes a memory cell array including a plurality of memory blocks, each memory block including a plurality of physical pages; the first physical page and the second physical page being located in a same memory block.

It should be noted that, in order to obtain balance in resources and time to reduce resource consumption and improve efficiency of read scrub operation, read scrub operation performed during power-on of the memory system do not need to traverse all physical pages in one memory block, in other words, read scrub operation may be performed in a sampling read scrub manner, for example, when performing a read scrub operation on a memory block, a read result of all physical pages coupled to at least one word line in the memory block is obtained, where the first physical page in the memory block is a target physical page of a read scrub operation in the plurality of physical pages, and the second physical page is another physical page other than the first physical page of the plurality of physical pages.

For example, a physical page 320 formed by a plurality of memory cells coupled to each word line shown in FIG. 3 (with the number of memory bits being one bit) is taken as an example for illustration. As shown in FIG. 3, each memory block 304 may be coupled to z word lines, where z is a positive integer. In some examples, when performing the read scrub operation on the memory block 304, a read result of all physical pages coupled to one word line in the memory block 304 is obtained, that is, a read result of a physical page is obtained. For example, the read result of the physical page 320 coupled to the x-th word line WLx shown in FIG. 3 is obtained. It may be understood that the x-th word line WLx is the target word line of the read scrub operation, and the physical page 320 coupled to the x-th word line WLx is the target physical page (that is, the first physical page) of the read scrub operation in the plurality of physical pages. The x-1 physical pages coupled to the first to (x-1)-th word lines (WL1, WL2, WL3, WL4 to WLx -1) are all second physical pages.

It may be understood that when a plurality of SLCs coupled to each word line form a physical page, obtaining a read result of all physical pages coupled to one word line in the memory block in the read scrub operation is obtaining a read result of a physical page coupled to the word line. When a plurality of MLCs coupled to each word line form two physical pages, obtaining a read result of all physical pages coupled to one word line in the memory block in the read scrub operation is obtaining a read result of two physical pages coupled to the word line. When a plurality of TLCs coupled to each word line form three physical pages, obtaining a read result of all physical pages coupled to one word line in the memory block in the read scrub operation is obtaining a read result of three physical pages coupled to the word line. In summary, all physical pages coupled to the target word line of the read scrub operation are the first physical pages.

FIG. 3 is merely an example, and is not intended to limit the number of word lines, physical pages and memory cells, and the specific structure of the memory device in the present disclosure.

In some examples, the periodicity of read scrub operations typically depends on the particular application scenario and needs. In general, the periodicity of read scrub may be determined according to factors such as data importance and sensitivity, frequency and load of usage of the system. For example, for important or sensitive data, more frequent read scrub may be required to ensure data integrity and reliability. High load systems may require more frequent read scrub to account for data changes and system loads.

Here, during power-on of the memory system, the regularly executed read scrub operation includes read scrub operations on different memory blocks. In the examples of the present disclosure, a process of performing read scrub operation on one of a plurality of memory blocks is taken as an example for illustration.

In some implementations, the preset model for generating the target reference voltage is related to a characteristic of the memory device, and the preset model may be obtained by fitting a large amount of experimental results before the memory device leaves the factory, and may be stored in the memory device.

For example, the preset model is encoded into the code, and the code is stored in firmware or software of the memory device.

In some examples, a large amount of data is collected through a large scale of experiments before the memory device leaves the factory, and is analyzed by preprocessing such as removing abnormal values, sorting, de-noising, etc., and the preset model is fitted by using a statistical method, machine learning, or other modeling techniques, where the parameters of the preset model include the first parameter.

In some examples, the preset model is a quadratic function model, and the first parameter is a curvature of a curve where the quadratic function model is located. The manner of obtaining the target reference voltage according to the preset model and the first parameter thereof is further described below.

In some examples, the preset model includes a quadratic function model, and the quadratic function model includes the following equation of the function:

$$y=a(x+b)^2 +c$$

Where y is a first result, x is a reference read voltage, b is used to represent a prediction parameter, a is a first parameter, and c is a second parameter.

For example, using a data driven method such as machine learning or deep learning, a preset model is established by collecting a large amount of reference read voltages and corresponding first results to represent a relationship between the reference read voltage and the first result, meanwhile the related parameters (for example, the first parameter and the second parameter) of the preset model are obtained.

The following describes a meaning of the first result and a way for obtaining the first result.

Here, the first result represents the number of bits of the physical page, on which the read operation is to be performed, that is flipped among the two read results under the first read voltage and the second read voltage.

Here, both the first read voltage and the second read voltage refer to a general concept, and a difference between the first read voltage and the second read voltage is less than a preset voltage. In some examples, the second read voltage is greater than the first read voltage, the difference between the first read voltage and the second read voltage ranges from 5mV to 20mV, and for example, the difference between the first read voltage and the second read voltage may be 5mV, 10mV, 15mV, 20mV. In some other examples, the second read voltage is less than the first read voltage, the difference between the first read voltage and the second read voltage ranges from -5mV to -20mV, and for example, the difference between the first read voltage and the second read voltage may be -5mV, -10mV, -15mV, and -20mV.

In some examples, the memory device is configured to: read the stored data of the physical page under the first read voltage, to obtain a second result; read the stored data of the physical page under the second read voltage, to obtain a third result; perform a logical operation on the second result and the third result, to obtain a fourth result; and count the number of bits in the fourth result representing that bits of the third result are flipped relative to the second result, to obtain the first result.

In some examples, the memory device includes: a first latch configured to store the second result; a second latch configured to store the third result; and a third latch configured to store the fourth result.

Here, the first read voltage and the second read voltage are interrelated, that is, the second read voltage is obtained by making a third adjustment based on the first read voltage. Based on this, the voltage difference between the first read voltage and the second read voltage is the third step size. In some examples, the third step size ranges from 5mV to 20mV, for example, the third step size may be 5mV, 10mV, 15mV, 20mV. The preset voltage is related to the third step size and may be a voltage slightly larger than the third step size. In some examples, the preset voltage ranges from 6mV to 21mV, for example, the preset voltage may be 6mV, 11mV, 16mV, 21mV. In some other examples, the preset voltage ranges from -6mV to -21mV, for example, the preset voltage may be -6mV, -10mV, -16mV, and -21mV.

As described above, both the first read voltage and the second read voltage refer to a general concept, both the target read voltage and the read voltage obtained after the first adjustment and the second adjustment made on the target read voltage may be referred to as the first read voltage, and the read voltage obtained after the third adjustment made on the first read voltage may be referred to as the second read voltage. That is, the first read voltage is a general concept, it may be understood as the target read voltage or the target adjusted read voltage (i.e. the voltage obtained after the target read voltage is adjusted by using the target step size, where the target step size may range from 20mV to 40mV, for example, the first step size of the first adjustment may be 20mV, 30mV, 40mV, and the target step size may also range from 50mV to 150mV, for example, the second step size of the second adjustment may be 50mV, 60mV, 70mV, 80mV, 100mV, 120mV, or 150mV).

In some examples, the memory controller is configured to: generate a first parameter of the second physical page according to a first parameter of the first physical page, a location relationship between the second physical page and the first physical page in combination with a mapping function, where the mapping function characterizes a relationship between first parameters of the plurality of physical pages.

It may be understood that when a large amount of experimental results are fitted to obtain the preset model and the first parameter before the memory device leaves the factory, the first parameters of the physical pages coupled to different word lines may be recorded, and the recorded first parameters of the physical pages coupled to different word lines may be analyzed and counted to establish the relationship between the first parameters of the physical pages coupled to different word lines. For example, according to the collected first parameters of the physical pages coupled to different word lines, the relationship between the location relationship of the physical pages coupled to different word lines and the first parameters of the physical pages coupled to different word lines may be established and presented in a mapping function.

In some examples, a number of memory bits of the memory cell is P bits, and P memory bits correspond to read voltages of $2^P$ -1 levels; where P is an integer greater than or equal to 1; and the mapping function includes $2^P$ -1 first mapping functions respectively corresponding to read voltages of the $2^P$ -1 levels.

In some examples, the P memory bits respectively correspond to a P pages, and the P-bits memory cell reads its P bits of stored data through read voltages of the $2^P$ -1 levels. It may be understood that the physical pages coupled to the same word line may have different first parameters under read voltages of different levels, so that the first parameters of the physical pages coupled to different word lines may have different relationships under read voltages of different levels and presented in a plurality of first mapping functions, where $2^P$ -1 first mapping functions may be the same or different.

For example, when the number of memory bits is 1, the mapping function comprises 1 first mapping functions corresponding to the relationship between the first parameters of the physical pages coupled to different word lines under 1 level of the read voltage; when the number of memory bits is 2, the mapping function comprises 3 first mapping functions respectively corresponding to the relationship between the first parameters of the physical pages coupled to different word lines under 3 levels of the read voltage; when the number of memory bits is 3, the mapping function comprises 7 first mapping functions respectively corresponding to the relationship between the first parameters of the physical pages coupled to different word lines under 7 levels of the read voltage; and when the number of memory bits is 4, the mapping function comprises 15 first mapping functions respectively corresponding to the relationship between the first parameters of the physical pages coupled to different word lines under 15 levels of the read voltage.

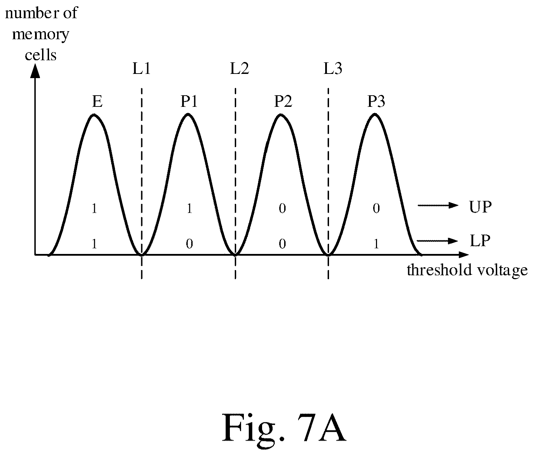

For example, when a number of memory bits of a memory cell includes two bits, the corresponding storage state includes a zero-th state to a third state, and referring to FIG. 7A, the 4 states are a zero-th state (also referred to as an erase state) E, a first state (also referred to as a first storage state) P1, a second state (also referred to as a second storage state) P2, and a third state (also referred to as a third storage state) P3, and binary data corresponding to the 4 states are 11, 10, 00, and 01, respectively. Correspondingly, the memory device includes two pages, namely lower page (LP) and upper page (UP) respectively.

Taking the memory cell shown in FIG. 7A as an example, the two-bit memory cell reads its stored data of two-bit four-state through read voltages of three levels (the first level read voltage L1, the second level read voltage L2, and the third level read voltage L3 shown in FIG. 7A).

For example, one page corresponds to a multi-level read voltage, and another page corresponds to the one level of read voltage. As shown in FIG. 7A, the binary data corresponding to the lower page is 1001, and to read the lower page requires corresponding a first level read voltage L1 and a third level read voltage L3. The binary data corresponding to the upper page is 1100, and to read the upper page requires corresponding second level read voltage L2.

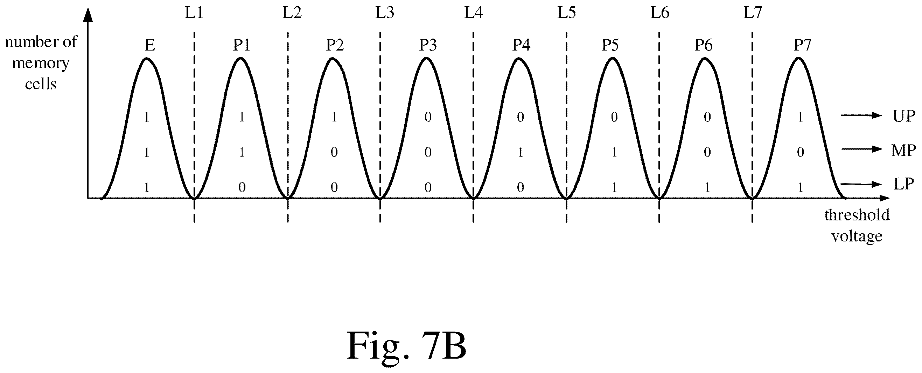

For example, when a number of memory bits of a memory cell includes three bits, the corresponding storage state includes a zero-th state to a seventh state, and referring to FIG. 7B, the 8 states are a zero-th state (also referred to as an erase state) E, a first state (also referred to as a first storage state) P1, a second state (also referred to as a second storage state) P2, ···, a seventh state (also referred to as a seventh storage state) P7, and binary data corresponding to the 8 states are 111, 110, 100, 000, 010, 011, 101, respectively. Correspondingly, the memory device includes three pages, namely a lower page, a middle page (MP), and an upper page.

Taking the memory cell shown in FIG. 7B as an example, the three-bit memory cell reads its stored data of three-bit eight state by read voltages of seven levels (the first level read voltage L1, the second level read voltage L2, the third level read voltage L3, the fourth level read voltage L4, the fifth level read voltage L5, the sixth level read voltage L6, the seventh level read voltage L7 shown in FIG. 7B).

For example, each page corresponds to a multi-level read voltage, as shown in FIG. 7B, the binary data corresponding to the lower page is 10000111, and to read the lower page requires corresponding first level read voltage L1 and the fifth level read voltage L5. The binary data corresponding to the middle page is 11001100, and to read the middle page requires corresponding second level read voltage L2, the fourth level read voltage L4, and the sixth level read voltage L6. The binary data corresponding to the upper page is 11100001, and to read the upper page requires corresponding third level read voltage L3 and the seventh level read voltage L7.

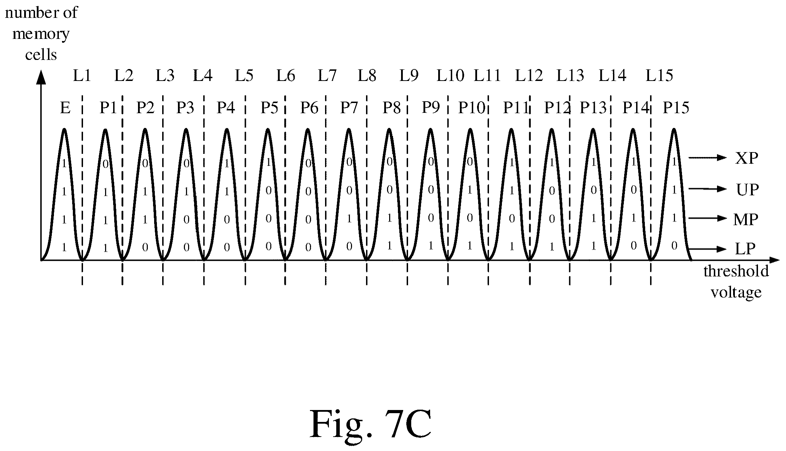

For example, when a number of memory bits of a memory cell includes four bits, the corresponding storage state includes a zero-th state to a fifteenth state, and referring to FIG. 7C, the 16 states are a zero-th state (also referred to as an erase state) E, a first state (also referred to as a first storage state) P1, a second state (also referred to as a second storage state) P2, ···, a fifteenth state (also referred to as a fifteenth storage state) P15, and binary data corresponding to the 16 states are 1111, 0111, 0110,···, 1110, respectively. Correspondingly, the memory device includes four pages, namely a lower page, a middle page, an upper page, and an extra page (XP). Here, four memory bits corresponding to the 16 states are respectively stored in a lower page, a middle page, an upper page, and an extra page.

Taking the memory cell shown in FIG. 7C as an example, the four-bit memory cell reads its stored data of the four bit sixteen states through read voltages of fifteen levels (the first level read voltage L1, the second level read voltage L2, the third level read voltage L3, the fourth level read voltage L4, the fifth level read voltage L5, the sixth level read voltage L6, the seventh level read voltage L7, the eighth level read voltage L8, the ninth level read voltage L9, the tenth level read voltage L10, the eleventh level read voltage L11, the twelfth level read voltage L12, the thirteenth level read voltage L13, the fourteenth level read voltage L14, and the fifteenth level read voltage L15 shown in FIG. 7C).

For example, each page corresponds to a multi-level read voltage, as shown in FIG. 7C, the binary data corresponding to the lower page is 1100000011111100, and to read lower page requires corresponding second level read voltage L2, the eighth level read voltage L8, and the fourteenth level read voltage L14. The binary data corresponding to the middle page is 1110000110000111, and to read the middle page requires corresponding third level read voltage L3, the seventh level read voltage L7, the ninth level read voltage L9, and the thirteenth level read voltage L13. The binary data corresponding to the upper page is 1111100000110001, and to read the upper page requires corresponding fifth level read voltage L5, the tenth level read voltage L10, the twelfth level read voltage L12, and the fifteenth level read voltage L15. The binary data corresponding to the extra page is 1000110000011111, and to read the extra page requires corresponding first level read voltage L1, the fourth level read voltage L4, the sixth level read voltage L6, and the eleventh level read voltage L11.

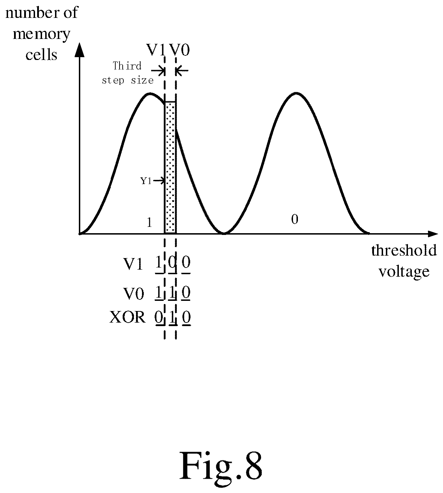

In the examples of the present disclosure, a first result corresponding to a voltage (for example, the first read voltage V0 shown in FIG. 8) may be understood as: performing a third adjustment on the voltage, that is, the voltage and a voltage after the third adjustment (for example, the second read voltage V1 shown in FIG. 8) have a first voltage difference $\Delta V1$, and a number of bits that are flipped between both read results of the physical page under the voltage and the voltage after the third adjustment may be used as a first result corresponding to the voltage.

In some examples, before obtaining the first result of the physical page corresponding to the target read voltage, the read mode of the memory device is set to a single level read (SLR); and the single level read includes reading at least one bit of stored data stored in the memory cell through the one level of read voltage.

In some examples, the memory device is configured to: in response to the mode setting command, enter the single level read, and obtain, in the single level read, a first result of the physical page corresponding to the target read voltage.

In some examples, the stored data of the physical page is read under the first read voltage to obtain a second result; the second result is stored in the first latch of the memory device. For example, as shown in FIG. 8, the stored data of the physical page is read under the first read voltage V0 to obtain a second result. For example, to obtain a second result, the memory cell with a threshold voltage less than the target read voltage V0 is marked as bit 1, and the memory cell with a threshold voltage greater than the target read voltage V0 is marked as bit 0, then the second result is stored in the first latch of the memory device.

Next, a third adjustment is performed on the first read voltage to obtain a second read voltage, and the stored data of the physical page is read under the second read voltage to obtain a third result; and the third result is stored in the second latch of the memory device. For example, as shown in FIG. 8, a third adjustment is performed on the first read voltage V0, and the stored data of the physical page is read under the second read voltage V1 after the adjustment to obtain a third result. For example, to obtain a third result, the memory cell with the threshold voltage less than the second read voltage V1 is marked as bit 1, and the memory cell with the threshold voltage greater than the second read voltage V1 is marked as bit 0, then the third result is stored in the second latch of the memory device.

Next, a logical operation is performed on the second result and the third result to obtain a fourth result; and the fourth result is stored in the third latch of the memory device. For example, as shown in FIG. 8, an XOR operation is performed on the second result and the third result to obtain a fourth result; and the fourth result is stored in the third latch of the memory device.

It should be noted that, the XOR operation is one of basic logic operations. In binary, if the two binary numbers of the same location are the same, the result is "0", and if the two binary numbers of the same location are different, the result is "1" (that is, 0 when the same, and 1 when different).

Next, the number of bits in the fourth result representing the third result is flipped relative to the second result is counted, so as to obtain the first result. For example, as shown in FIG. 8, a part of the fourth result with a bit of 1 represents a number of memory cells with different threshold voltages between the first read voltage V0 and the second read voltage V1. In other words, the part of the fourth result with a bit of 1 represents a number of bits that is flipped when comparing both read results of the physical page under the first read voltage V0 and the second read voltage V1, and the number is denoted as a first result Y1 corresponding to the first read voltage V0.

In some examples, the plurality of word lines includes Q word line groups (WL Group), the first mapping function includes Q second mapping functions corresponding to the Q word line groups respectively. A relationship between first parameters of the physical pages coupled to each word line in a same word line group conforms to a corresponding second mapping function, where Q is an integer greater than or equal to 1. The memory controller is configured to: when obtaining the first parameter of the first physical page, obtain a first parameter of a physical page coupled to at least one word line in each of the Q word line groups.

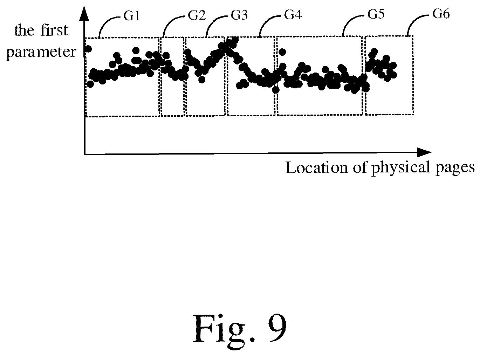

As shown in FIG. 9, the location or number of the physical page in the memory block is taken as the abscissa, the first parameter corresponding to the physical page is taken as the ordinate, and the abscissa and the ordinate form a point. For example, the plurality of word lines includes 6 word line groups (G1, G2, G3, G4, G5, and G6), or may be referred to as a physical page group. The first mapping function of the first parameter of the physical page coupled to different word lines under the fourth level read voltage L4 includes 6 second mapping functions corresponding to the 6 word line groups respectively, and a relationship between the first parameters of the physical pages coupled to the word lines in the same word line group conforms to the corresponding second mapping function. For example, in the scenario shown in FIG. 9, for a memory system including a three-bit memory cell, a mapping function of a relationship between first parameters of physical pages coupled to different word lines includes 7 first mapping functions, at least one first mapping function includes 6 second mapping functions, where 7 first mapping functions may be the same or different.

It may be understood that, when a large amount of experimental results are fitted to obtain the preset model and the first parameter before the memory device leaves the factory, the relationship between the first parameters of the physical pages coupled to different word lines under the same level of read voltage may be described with the first mapping function, where the first mapping function may include a plurality of second mapping functions, that is, the first mapping function may be a set of mapping functions comprising a plurality of second mapping functions. Each second mapping function is used to describe a relationship between first parameters of physical pages in different locations in a same memory block. Therefore, the plurality of word lines may be grouped according to actual experimental results to more accurately describe the relationship between the first parameters of the physical pages coupled to different word lines with the second mapping function.

In this way, the relationship between the first parameters of a larger number of physical pages can be advantageously managed, so that the performance of the memory system can be further optimized by using the relationship between the first parameters of the physical pages.

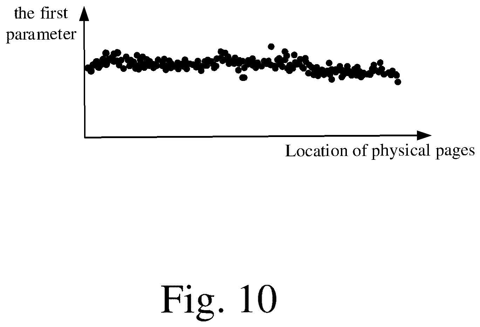

As shown in FIG. 10, the relationship between the first parameters of all physical pages in the same memory block may be described with one second mapping function, that is, the first mapping function of the first parameter of the physical page coupled to different word lines under the seventh level read voltage L7 includes one second mapping function corresponding to one word line group.

It should be noted that the number of the first mapping function and the number of the second mapping function provided in an example of the present disclosure is merely an example, and the actual number of the first mapping function and the second mapping function is related to the feature of the memory device, and should not excessively limit the scope of the present disclosure.

In some examples, the memory controller is configured to: obtain a first parameter of a physical page coupled to at least one word line in each of the Q word line groups when obtaining the first parameter of the first physical page. In this way, it can be ensured that each word line group has a first parameter of a representative physical page for obtaining first parameters of remaining physical pages in the same word line group, so as to perform specific adjustment and optimization on different word line groups according to a second mapping function, thereby improving overall performance and stability of the memory system.

The first parameter is a key parameter in the preset model used for generating the target reference voltage. By pre-establishing a relationship between first parameters of physical pages coupled to different word lines and a table of first parameter values corresponding to each physical page, the first parameter of the remaining physical pages (the second physical page) can be dynamically generated in combination with the mapping function according to the first parameter of part of physical pages (the first physical page) and the location relationship between the physical pages (the second physical page and the first physical page) coupled to different word lines in the read scrub operation process, and the first parameter of the first physical page and the first parameter of the second physical page are stored, the read scrub efficiency can be improved, and the data integrity and reliability can be protected.

In some examples, the memory controller is configured to: during a read operation after a read scrub operation is performed, obtain a target reference voltage of at least one of the second physical pages based on a stored first parameter of the second physical page; and perform a read operation on at least one of the second physical pages according to the obtained target reference voltage of at least one of the second physical pages.

In some examples, by dynamically updating the first parameter of the second physical page during the read operation after the read scrub operation, it facilitates obtaining the target reference voltage according to the newest first parameter during the subsequent read operation, so that the read operation is more accurate, and the probability of decoding failure is reduced.

In some examples, the Nth updated parameter table includes the Nth stored first parameter of the first physical page and the first parameter of the second physical page. The memory controller is configured to: in the process of performing the read scrub operation, obtain a read result of the first physical page; if the read results are not decoded successfully, update the first parameter of the first physical page based on the first parameter of the first physical page stored in the Nth updated parameter table; and generate the first parameter of the second physical page according to the updated first parameter of the first physical page; and store the updated first parameter of the first physical page and the generated first parameter of the second physical page for the (N + 1)th time as the (N + 1)th updated parameter table; N is a positive integer.

In some examples, the initial mapping table of the relationship between the first parameters of the physical pages coupled to different word lines is established before the memory device leaves the factory, and the read result of the first physical page is obtained in the process of performing the read scrub operation for the first time; if the read results are not decoded successfully, the first parameter of the first physical page is updated based on the first parameter of the first physical page stored in the first updated parameter table (i.e., the initial mapping table), and the first parameter of the second physical page is generated according to the updated first parameter of the first physical page; and the updated first parameter of the first physical page and the generated first parameter of the second physical page are stored for the second time as the second updated parameter table.

It should be noted that the determining condition of the failure of decoding the read result is that the fail bit count of the read result is less than or equal to the third setting threshold, where the third preset threshold may be less than or equal to the first preset threshold. It can be understood that, in the process of performing the read scrub operation, when the fail bit count of the obtained read result is lower than or equal to the error correction early warning value of the data of the memory cell, the parameter table is updated to obtain the target reference voltage to improve the correctness of the read data and avoid further expansion of the error or losing data, thereby ensuring dynamic adjustment (update) of the parameter table when the errors in data have not yet resulted in serious impact, and avoiding triggering a read retry operation or an error correction rewriting operation.

In some examples, the memory controller is configured to: in response to the memory system being powered on, load a relation table characterizing the mapping function and the Nth updated parameter table from the memory device; and in response to the memory system being powered off, store the (N + 1)th updated parameter table in the memory device.

In some examples, in response to the memory system being powered on, the newest relation table of mapping function and the parameter table are loaded, to ensure that the memory system uses the newest first parameter value at startup. In response to the memory system being powered off, the newest parameter table is stored, and it can be ensured that the newest first parameter can continue to be used during the memory system's next startup.

It should be noted that, during power-on of the memory system, the read scrub process performed on other memory blocks in the read scrub operation periodically executed may refer to the related description in the foregoing examples, and details are not described herein again.

Next, the process of obtaining the target reference voltage according to the preset model and the first parameter thereof is described in detail.

In some examples, the memory controller is configured to: obtain M first results of the physical page corresponding to M reference read voltages; the first result includes a number of bits flipped between two read results of the physical page under a first read voltage and a second read voltage; a difference between the first read voltage and the second read voltage is less than a preset voltage; M is an integer greater than or equal to 2; obtain a predicted reference voltage according to the M first results and the M reference read voltages in combination with the quadratic function model and a first parameter in a Nth updated mapping table; the quadratic function model characterizes a relationship between the first result and the reference read voltage; the M first results are all within a first preset interval; and determine a target reference voltage and a first parameter in an (N + 1)th updated parameter table based on the predicted reference voltage.

It should be noted that the predicted reference voltage herein may be directly used as the target reference voltage to perform a read operation on the data to be read as needed, or the target reference voltage can be obtained after performing further processing on the predicted reference voltage. The way to obtain the predicted reference voltage is further described below.

In some examples, the preset model is a quadratic function model, and the first preset interval represents a range between a first threshold and a second threshold of a curve where the quadratic function model is located; the first threshold is greater than the second threshold.

In some examples, the memory controller is configured to: obtain a first result of the physical page corresponding to a target read voltage; and according to the first result of the physical page corresponding to the target read voltage being within the first preset interval, use the target read voltage as a reference read voltage, and use the first result in the first preset interval as a first result corresponding to the reference read voltage.

In some examples, the memory controller is configured to: obtain a prediction parameter of the quadratic function model according to the M first results and the M reference read voltages in combination with the quadratic function model; the prediction parameter is a corresponding reference read voltage when a first result in a curve where the quadratic function model is located is minimum; obtain a predicted reference voltage according to the prediction parameter; and determine a target reference voltage and a first parameter in the (N + 1) th updated parameter table based on the predicted reference voltage.

In some implementations, the equation in the fitted preset model includes the related parameter, and when the predicted reference voltage is obtained, the value of the related parameter may be obtained according to the M first results and the M reference read voltages and the equation. Then obtain the corresponding reference read voltage when the first result in the curve where the preset model is located is minimum. And the corresponding reference read voltage when the first result in the curve where the preset model is located is minimum may be the predicted reference voltage. In some examples, the preset model includes a quadratic function model, and the quadratic function model includes the following equation:

$$y=a(x+b)^2 +c$$

Where y is a first result, x is a reference read voltage, b is used to represent a prediction parameter, a is a first parameter, and c is a second parameter.

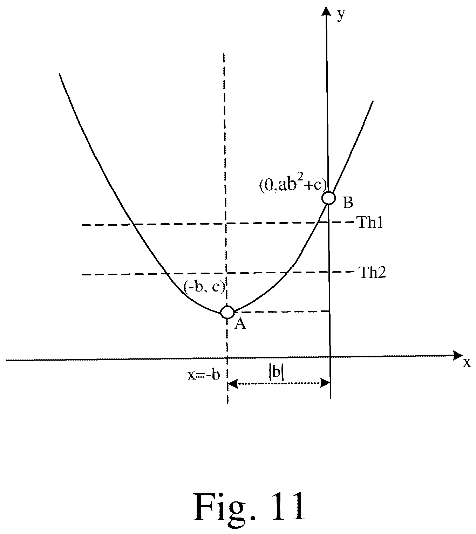

As shown in FIG. 11, it can be learned from the equation included in the quadratic function model that, the extreme value of the curve where the quadratic function model is located is at x = - b, where the axis of symmetry is located, i.e., a location where the derivative of the curve is 0. For example, when the first parameter is greater than 0, a corresponding y value (a first result) at x = - b is a minimum value of a curve where the quadratic function model is located, and a coordinate of the extreme point (point A shown in FIG. 10) is (-b, c).

In some implementations, the value of the prediction parameter is the opposite number of b, that is, the prediction parameter represents the abscissa corresponding to the minimum value of the curve where the quadratic function model is located.

As shown in FIG. 11, the offset value of the axis of symmetry (x = - b) of the curve (where the quadratic function model is located) relative to the y axis (x = 0) is -b, that is, the distance between the axis of symmetry of the curve (where the quadratic function model is located) and the y axis is the absolute value | b | of b.

Here, x = 0 may be understood as the location of the default read voltage, the term "the first result corresponding to the default read voltage" in the present disclosure may be referred to as "default first result", and the coordinate corresponding to the default first result (point B shown in FIG. 11) is $(0, ab^2 + c)$. The default read voltage may be a read voltage when the threshold voltage of the memory cell is not offset, for example, a corresponding read voltage when being written at the beginning, and the corresponding offset value is 0. It can be understood that when the offset value of the target read voltage relative to the default read voltage (x = 0) is - b, the first result corresponding to the target read voltage is the minimum value. It may be understood that by using the corresponding target read voltage (here equivalent to the prediction parameter) as the predicted reference voltage when the first result is the minimum value, and determining the target reference voltage based on the predicted reference voltage, the error rate of the read result is low, and the reliability is high.

It should be noted that when using the corresponding target read voltage (here equivalent to the prediction parameter) as the predicted reference voltage when the first result is the minimum value, that is, using -b as the predicted reference voltage, it represents the offset value of the predicted reference voltage relative to the default read voltage is -b, and does not represent the predicted reference voltage is negative. When -b is greater than 0, it indicates that the predicted reference voltage is |b| to the right to the default read voltage, and when -b is less than 0, it indicates that the predicted reference voltage is |b| to the left to the default read voltage. In other words, the relationship between the actual voltage of the predicted reference voltage (denoted as Vpre) and the actual voltage of the default read voltage (denoted as Vdefault) is as follows:

$$Vpre=Vdefault+(-b)$$

Similarly, after the target reference voltage is determined based on the predicted reference voltage, using the target reference voltage to perform the read operation on the physical page refer to using the actual voltage of the target reference voltage to perform the read operation on the physical page. It should be noted that there exist and there is only one set of prediction parameters, it is directly used as the prediction reference voltage. However, when there are multiple sets of prediction parameters, it is necessary to jointly determine the prediction reference voltage according to the multiple sets of prediction parameters.

In some examples, as shown in FIG. 11, the first preset interval represents a range between the first threshold and the second threshold of the curve where the quadratic function model is located; the first threshold (Th1) is greater than the second threshold (Th2).

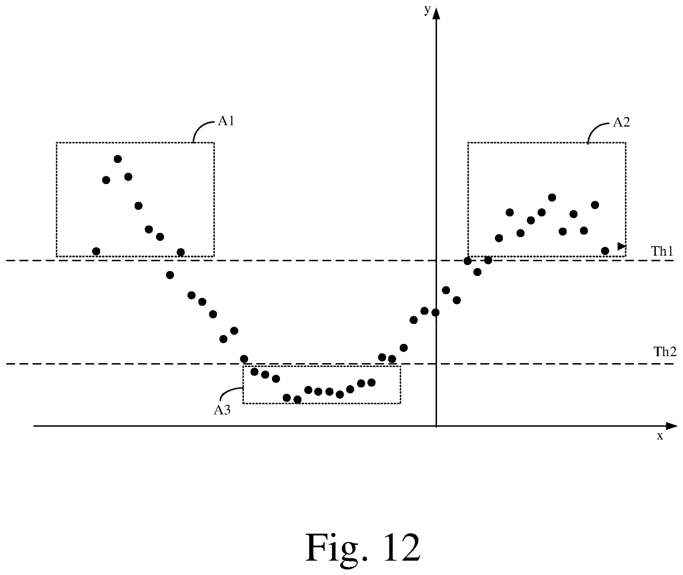

FIG. 12 is a schematic diagram of determining a first preset interval according to an example of the present disclosure. In some examples, the plurality of solid dots shown in FIG. 12 represent a large amount of data (the plurality of target read voltages and the plurality of first results corresponding to the plurality of target read voltages) collected through a large number of experiments before the memory device leaves the factory, and when the preset model is fitted based on the data shown in FIG. 12, the data selection is directly related to the accuracy of the preset model obtained by fitting. For example, when the first result of the selected data is too high (for example, the solid dots in the dotted box region A1 or the dotted box region A2 shown in FIG. 12), the preset model obtained by fitting will be different from the distribution curve of the actual threshold voltage, and for example, the preset model obtained by fitting the selected solid dots in the dotted box region A1 or the dotted box region A2 is the quadratic function model with a downward opening, which is not consistent with the distribution curve of the actual threshold voltage (quadratic function model with an upward opening). When the first result of the selected data is too low (for example, the solid dots in the dotted box region A3 shown in FIG. 12), the error of the preset model obtained by fitting is too large, causing that the location deviation between the target reference voltage obtained according to the preset model and the actual read voltage is too large.

In some examples, the range of the first preset interval is from 50 to 200.

It should be noted that the range of the first preset interval provided in this example of the present disclosure is merely an example, the range of the first preset interval is related to a characteristic of the memory device, and the protection scope of the present disclosure should not be limited.

In some examples, the memory controller is configured to: obtain a first result of the physical page corresponding to a target read voltage; and use the target read voltage as a reference read voltage according to the first result of the physical page corresponding to the target read voltage being within the first preset interval; and re-obtain at least one new target read voltage according to the first result of the physical page corresponding to the target read voltage being outside the first preset interval, and obtain a first result corresponding to the at least one new target read voltage, until the first result corresponding to the newest target read voltage is within the first preset interval.

Here, the first parameter and the second parameter may be obtained when fitting the preset model and stored in the memory device.

For example, the preset model includes a quadratic function model, and the quadratic function model includes the following equation (1):

$$y=a(x+b)^2+c$$

The first parameter and the second parameter in the equation may be optimized using, but not limited to, least square method, gradient descent method, Bayesian optimization, Newton method, and quasi-Newton method, and the optimal first parameter and second parameter may be stored in the memory device. The least square method is a parameter estimation method, and parameters are estimated by minimizing a sum of squares of residuals between actual collected data and predicted values of a quadratic function model. The gradient descent method is to use a parameter of the quadratic function model as an optimization target, use a gradient descent method to find a parameter value that minimizes a fitting error of the quadratic function model, calculate a gradient of a loss function with respect to the first parameter and the second parameter, and then update values of the first parameter and the second parameter along the reverse direction of the gradient until convergence is reached.

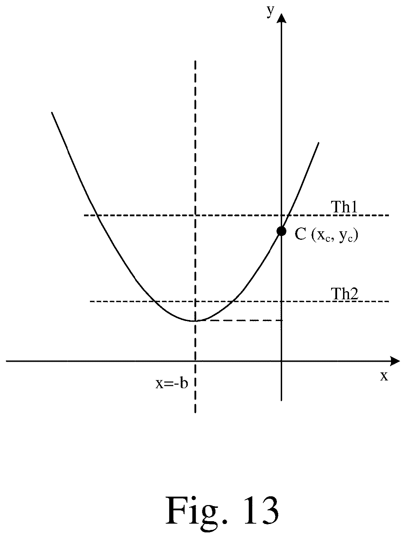

In some examples, as shown in FIG. 13, the memory controller is configured to: obtain a first result of the physical page corresponding to the target read voltage, that is, obtain the point C $(x_c, y_c)$ shown in FIG. 13; the first result corresponding to the point C $(y_c)$ is within the first preset interval, and uses the target read voltage $(x_c)$ corresponding to the point C as a reference read voltage.

It should be noted that the default first result being the point C is taken as an example in FIG. 13, and should not limit the protection scope of the present disclosure. In addition, the point C is a point corresponding to the first result obtained under the default read voltage in the manner of obtaining the first result in the foregoing example, so the point C is an actual value, may or may not be located on the curve where the quadratic function model is located.

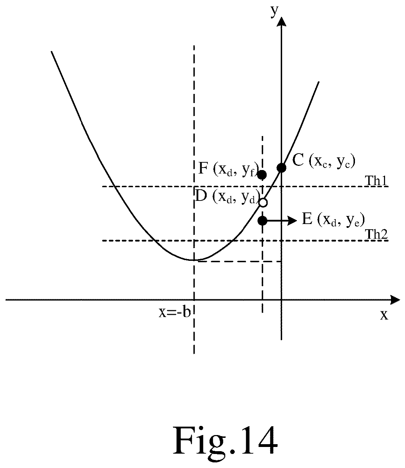

In some examples, as shown in FIG. 14, the memory controller is configured to: according to a first result $(y_c)$ to the point C $(x_c, y_c)$ being outside a first preset interval, re-obtain at least one new target read voltage, and obtain a corresponding first result corresponding to the at least one new target read voltage until the first result corresponding to the newest target read voltage is within the first preset interval.

It can be understood that only when the first result corresponding to the target read voltage is within the first preset interval, the target read voltage can be used as the reference read voltage to obtain the predicted reference voltage. In this way, accuracy and reliability of obtaining the predicted reference voltage based on the plurality of reference read voltages and the plurality of first results can be enhanced.

In some examples, at least two of the M reference read voltages are at both two sides of an axis of symmetry of a curve where the quadratic function model is located; the memory controller is configured to: obtain a reference read voltage at a first side of the two sides of an axis of symmetry of a curve where the quadratic function model is located when obtaining the reference read voltage; and determine a reference read voltage at a second side of the two sides of the axis of symmetry according to the reference read voltage at the first side.

In some examples, the first parameter and the second parameter may be derived when fitting the preset model and stored in the memory device. An initial b value may be obtained according to a coordinate of the point C in FIG. 13 or FIG. 14, the equation of the quadratic function model, the first parameter, and the second parameter. The axis of symmetry $x = -b$ of the curve where the quadratic function model is located can be obtained according to the initial b value.

It should be noted that the first side refers to one side of the axis of symmetry ($x = -b$ as shown in FIG. 13 and FIG. 14) of the curve where the quadratic function model is located, and the second side refers to the other side of the axis of symmetry of the curve where the quadratic function model is located. When the first side is the right side of the axis of symmetry, the second side is the left side of the axis of symmetry. When the first side is the left side of the axis of symmetry, the second side is the right side of the axis of symmetry.

For example, the target read voltage $(x_c)$ corresponding to the point C in FIG. 13 is the reference read voltage at the first side of the two sides of the axis of symmetry of the curve where the quadratic function model is located.

Next, the process of obtaining the reference read voltage at the first side of the two sides of the axis of symmetry of the curve where the quadratic function model is located and obtaining the reference read voltage at the second side of the two sides of the axis of symmetry will be described in detail.

In some examples, the method for re-obtaining the at least one new target read voltage according to the first result of the physical page corresponding to the target read voltage is outside the first preset interval includes, but is not limited to, after the target read voltage is adjusted by the target step size, using the resulting read voltage as the new target read voltage. For example, as shown in FIG. 14, the read voltage $(x_d)$, obtained after the target read voltage $(x_c)$ is adjusted by the target step size, is used as the new target read voltage. The first result $(y_e)$ of the physical page corresponding to the new target read voltage is obtained, that is, the point E $(x_d, y_e)$ shown in FIG. 14 is obtained. In this case the point E is an actual value. When the first result $(y_e)$ corresponding to the point E is within the first preset interval, the new target read voltage $(x_d)$ corresponding to the point E is used as a reference read voltage. Wherein, the range of the target step size may be set to 20 mV to 40 mV, for example, the step size of the first adjustment may be 20 mV, 30 mV, 40 mV. The range of the target step size may also be set to 50 mV to 150 mV, for example, the step size of the second adjustment may be 50 mV, 60 mV, 70 mV, 80 mV, 100 mV, 120 mV, or 150 mV.

In some implementations, the memory controller is configured to: according to the first result of the physical page corresponding to the target read voltage being outside the first preset interval, obtain a fitted read voltage at the first side corresponding to the target first result based on the target read voltage, the first result corresponding to the target read voltage, the target first result, and the third mapping function; the third mapping function being obtained according to the quadratic function model, the first parameter, and the second parameter; the target first result being within a second preset interval, and the first preset interval being within a range of the second preset interval.

For example, as shown in FIG. 14, the memory controller is configured to: according to the first result $(y_c)$ corresponding to the point C $(x_c, y_c)$ being outside the first preset interval, obtain the fitted read voltage $(x_d)$ at the first side corresponding to the target first result $(y_q)$ based on the target read voltage $(x_c)$, the first result $(y_c)$ corresponding to the target read voltage, the target first result ($y_d$), and the third mapping function, that is, obtain the point D ($x_d$,$y_d$) according to the coordinates of the point C, the target first result ($y_d$), and the third mapping function. The third mapping function includes the following equation (2):

$$x2 = x1 - \sqrt{\frac{y1-c}{a}} + \sqrt{\frac{y2-c}{a}}$$

Where x1 and y1 respectively represent the abscissa and ordinate of the obtained actual point, y2 represents the target first result which is a random value in the second preset interval, and x2 represents the fitted read voltage. The third mapping function is intended to obtain a fitted read voltage (for example, $x_d$ shown in FIG. 14) according to a value in the second preset interval in combination with the obtained actual point (for example, the point C). The first preset interval is within a range of the second preset interval. Optionally, the second preset interval ranges from 30 to 220.

The coordinates of the point C, the target first result ($y_d$), the first parameter and the second parameter are substituted into the equation (2) of the first mapping function to obtain the point D ($x_d$,$y_d$).

It should be noted that FIG. 14 and the third mapping function are described by taking the first side as the right side of the axis of symmetry and the point C at the first side.

In this case, the point D ($x_d$,$y_d$) is a fitted point, the abscissa $x_d$ corresponding to the point D is the fitted read voltage at the first side, and the memory controller is configured to: use the fitted read voltage as a new target read voltage, obtain a first result ($y_e$) of the physical page corresponding to the fitted read voltage ($x_d$) at the first side in the manner of obtaining the first result in the foregoing example, that is, obtain the point E ($x_d$,$y_e$), and the point E is the actual point; and use the fitted read voltage ($x_d$) at the first side as a reference read voltage at the first side according to the first result (the ordinate $y_e$ corresponding to the point E) corresponding to the fitted read voltage at the first side being within the first preset interval.

In some examples, use the fitted read voltage (the abscissa $x_d$ corresponding to the point D) at the first side as a new target read voltage, and obtain a first result ($y_f$) of the physical page corresponding to the fitted read voltage ($x_d$) at the first side in the manner of obtaining the first result in the foregoing example, that is, obtain the point F ($x_d$,$y_f$). The memory controller is further configured to: according to the first result (the ordinate $y_f$ of the point F) corresponding to the fitted read voltage at the first side being outside the first preset interval, obtain a next fitted read voltage at the first side corresponding to the target first result based on a last fitted read voltage at the first side, a last first result corresponding to the last fitted read voltage at the first side, the target first result, and the third mapping function, until the newest first result corresponding to the fitted read voltage at the first side is within the first preset interval, and use the newest fitted read voltage at the first side as a reference read voltage at the first side. It may be understood that it is obtaining the next fitted read voltage at the first side corresponding to the target first result based on the last known actual point F ($x_d$,$y_f$), the target first result (a random value different from $y_d$ in the second preset interval), and the third mapping function i.e. equation (2), until the newest first result corresponding to the fitted read voltage at the first side is within the first preset interval, and then using the newest fitted read voltage at the first side as a reference read voltage at the first side.

In some examples, the memory controller is configured to: adjust the value of the first parameter according to the number of times that the newest first result corresponding to the fitted read voltage at the first side is outside the first preset interval is greater than or equal to the preset number of times, and correspondingly adjust the third mapping function; obtain a next adjusted fitted read voltage at the first side corresponding to the target first result based on the last fitted read voltage at the first side, the last first result corresponding to the fitted read voltage at the first side, the target first result, and the adjusted third mapping function, until the newest first result corresponding to the adjusted fitted read voltage at the first side is within the first preset interval.

Here, the preset number of times represents the upper limit of the number of trials of using the preset model, and if, after the preset number of times of trials, the first results corresponding to the fitted read voltage at the first side obtained by using the preset model are all outside the first preset interval, it means that the selected preset model may not meet the actual requirement, and a further parameter adjustment is required. The preset number of times may be adjusted according to actual conditions, in some examples, the preset number of times are 3-7 times, for example, the preset number of times may be 3, 5, or 7.

In some examples, when the number of times, that the first result corresponding to the fitted read voltage at the first side obtained by the method in the foregoing example is outside the first preset interval, is greater than or equal to the preset number of times, it indicates that a plurality of actual points have been obtained at this time. The value of the adjusted first parameter may be obtained according to the obtained plurality of actual points in combination with the equation (1) and the second parameter (a constant) of the quadratic function model. It can be understood that adjusting the first parameter of the quadratic function model in combination with the actual point during actual use can improve the accuracy and reliability of the quadratic function model, and can make the adjusted first parameter infinitely close to the first parameter corresponding to the actual read voltage distribution curve. Therefore, the actual situation can be better reflected, the change of the actual use scene can be flexibly applied, and the practicability of the quadratic function model is improved.

For example, the preset number of times is 3, and the number of times that the first result corresponding to the fitted read voltage at the first side obtained by the method in the foregoing example is outside the first preset interval is equal to 3, that is, at least 3 actual points are obtained, and coordinates of the 3 actual points are denoted as (x3, y3) and (x4, y4), and (x5, y5) respectively. According to any 2 actual points in the obtained 3 actual points, such as (x3, y3) and (x4, y4), in combination with the equation (1) of the quadratic function model, a formula (1) to obtain b may be as follows:

$$b = \frac{x4 - x3}{1 + \sqrt{\dfrac{y3 - c}{y4 - c}}} - x4$$

Based on the formula (1) to obtain b, according to the equation of the quadratic function model and the second parameter being a constant, the formula (2) of the first parameter may be as follows:

$$a = \frac{y3 - c}{(x3 + b)^2}$$

It may be understood that the first parameter obtained herein may be used as the first parameter in the (N+1)th updated parameter table.

For example, according to the obtained 3 actual points in combination with the equation (1) of the quadratic function model, the formula (3) to obtain b may be as follows:

$$b = \frac{(y4 - y3) \times (x5^2 - x4^2) - (y5 - y4) \times (x4^2 - x3^2)}{2 \times ((y5 - y4) \times (x4 - x3) - (y4 - y3) \times (x5 - x4))}$$

Based on the calculation formula (3) of b, according to the equation (1) of the quadratic function model and the second parameter being constant, the calculation formula (4) of the first parameter may be as follows:

$$a = \frac{y4 - y3}{(x4^2 - x3^2) + 2 \times (x4 - x3) \times b}$$

In this way, the adjusted value of the first parameter is obtained, and the adjusted value of the first parameter is substituted into the equation (2) of the third mapping function to correspondingly adjust the third mapping function.

In some examples, the memory controller is configured to: obtain a fitted read voltage at the second side corresponding to the target first result based on a reference read voltage at the first side, a first result corresponding to a reference read voltage at the first side, a target first result, and a fourth mapping function, wherein the fourth mapping function is obtained according to the quadratic function model, the first parameter / adjusted first parameter, and the second parameter; obtain a first result of the physical page corresponding to the fitted read voltage at the second side; and use the fitted read voltage at the second side as a reference read voltage at the second side according to the first result corresponding to the fitted read voltage at the second side being within the preset interval.

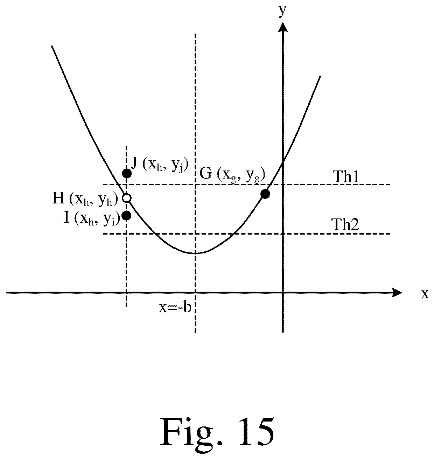

For example, as shown in FIG. 15, the memory controller is configured to: obtain a fitted read voltage ($x_h$) at the second side corresponding to the target first result ($y_h$) based on a reference read voltage (abscissa $x_g$ corresponding to the point G) at the first side, a first result (ordinate $y_g$ corresponding to the point G) corresponding to the reference read voltage at the first side, a target first result ($y_h$) and a fourth mapping function, that is, obtain a fitted read voltage ($x_h$) at the second side corresponding to the target first result ($y_h$) according to the coordinates of the point G, for example, obtain the point H ($x_h,y_h$) according to the coordinates of the point G, the target first result ($y_h$) and the fourth mapping function, wherein the fourth mapping function includes the following equation (3):

$$x2 = x1 - \sqrt{\frac{y1 - c}{a}} - \sqrt{\frac{y2 - c}{a}}$$

Where x1 and y1 respectively represent the abscissa and ordinate of the obtained actual point, y2 represents the target first result which is a random value in the second preset interval, and x2 represents the fitted read voltage. The fourth mapping function is intended to obtain the fitted read voltage (for example, $x_h$ shown in FIG. 15) according to a value in the second preset interval in combination with the obtained actual point (for example, the point G).

The coordinates of the point G, the target first result ($y_h$), the first parameter / adjusted first parameter, and the second parameter are substituted into the fourth mapping equation (3) to obtain the point H ($x_h,y_h$).

At this time, the point H ($x_h,y_h$) is a fitted point, the abscissa $x_h$ corresponding to the point H is the fitted read voltage at the second side, and the memory controller is configured to: use the fitted read voltage as a new target read voltage; obtain a first result ($y_i$) of the physical page corresponding to the fitted read voltage ($x_h$) at the second side in the manner of obtaining the first result in the foregoing example, that is, obtain the point I ($x_h,y_i$), where the point I is the actual point; and use the fitted read voltage ($x_h$) at the second side as a reference read voltage at the second side according to the first result (ordinate $y_i$ corresponding to the point I) corresponding to the fitted read voltage at the second side being within the first preset interval.

In some examples, the memory controller is configured to: according to the first result corresponding to the fitted read voltage at the second side being outside the preset interval, obtain a next fitted read voltage at the second side corresponding to the target first result based on a last fitted read voltage at the second side, a first result corresponding to the last fitted read voltage at the second side, the target first result and the fifth mapping function, until the newest first result corresponding to the fitted read voltage at the second side is within the first preset interval, and use the newest fitted read voltage at the second side as a reference read voltage at the second side. The fifth mapping function is obtained according to the quadratic function model, the first parameter/the adjusted first parameter and the second parameter.

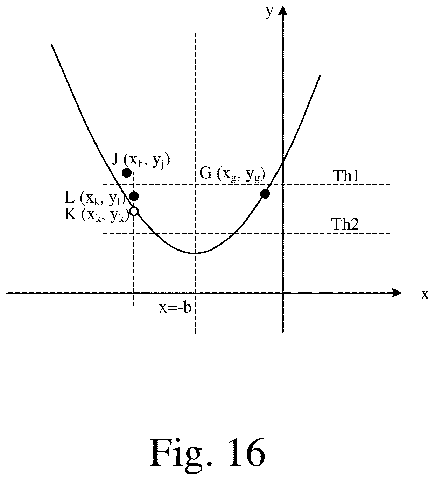

In some examples, as shown in FIG. 15 and FIG. 16, it is using the fitted read voltage at the second side (the abscissa $x_h$ corresponding to the point H) as the new target read voltage, and obtaining the first result ($y_j$) corresponding to the fitted read voltage ($x_h$) at the second side in the manner of obtaining the first result in the foregoing example, that is, obtaining the point J ($x_h,y_j$). The peripheral circuit is further configured to: according to the first result (the ordinate $y_j$ of the point J) corresponding to the fitted read voltage at the second side being outside the first preset interval, obtain a next fitted read voltage ($x_k$) at the second side corresponding to the target first result ($y_k$) based on a last fitted read voltage (the abscissa $x_h$ of the point J) at the second side, a first result (the ordinate $y_j$ of the point J) corresponding to the last fitted read voltage at the second side, the target first result ($y_k$) and the fifth mapping function, that is, obtain the point K ($x_k,y_k$) shown in FIG. 16, until the newest first result ($y_l$) corresponding to the fitted read voltage ($x_k$) at the second side is within the first preset interval, i.e. until the ordinate of the point L ($x_k,y_l$) shown in FIG. 16 is within the first preset interval, and use the newest fitted read voltage ($x_k$) at the second side as a reference read voltage at the second side; the fifth mapping function is obtained according to the quadratic function model, the first parameter/the adjusted first parameter and the second parameter. Wherein, the fifth mapping function includes the following relation (4):

$$x2 = x1 + \sqrt{\frac{y1 - c}{a}} - \sqrt{\frac{y2 - c}{a}}$$

Where x1 and y1 respectively represent the abscissa and ordinate of the obtained actual point, y2 represents the target first result which is an random value in the second preset interval, and x2 represents the fitted read voltage. The third mapping function is intended to obtain a fitted read voltage (for example, $x_k$ shown in FIG. 16) according to a value in the second preset interval in combination with an obtained actual point (for example, the point J).

The coordinates of the point J, the target first result ($y_k$), the first parameter / the adjusted first parameter, and the second parameter are substituted into the equation (4) of the fifth mapping function to obtain the point K ($x_k,y_k$).

In this case, the point K ($x_k,y_k$) is a fitted point, the abscissa $x_h$ corresponding to the point H is the fitted read voltage at the second side, and the memory controller is configured to: use the fitted read voltage as a new target read voltage, obtain a first result ($y_l$) of the physical page corresponding to the fitted read voltage ($x_k$) at the second side in the manner of obtaining the first result in the foregoing example, that is, obtain the point L ($x_k,y_l$), where the point L is the actual point; and use the newest fitted read voltage ($x_k$) at the second side as a reference read voltage at the second side according to the newest first result (ordinate $y_l$ corresponding to the point L) corresponding to the fitted read voltage at the second side is within the first preset interval.

It should be noted that the point A, the point B, the point D, the point H, and the point K in the examples of the present disclosure are fitted points, and are located on the curve where the quadratic function model is located. The point C, the point E, the point F, the point G, the point I, the point J and the point L are actual points, and may or may not be located on the curve where the quadratic function model is located.

In the examples of the present disclosure, the M reference read voltages and the first results corresponding to the M reference read voltages may be obtained by using the way to obtain the reference read voltage at the first side / the second side in the foregoing examples, and the prediction parameters are obtained based on the M reference read voltages and the M first results.

In some examples, the first parameter is a variable and the second parameter is a constant. The memory controller is configured to: obtain a prediction parameter according to the M first results and the M reference read voltages in combination with a quadratic function model; and use the prediction parameter as the predicted reference voltage.

For example, the N groups of prediction parameters may be obtained according to the M first results, the M reference read voltages, the quadratic function model, and the second parameter, where N is equal to $C_M^2$.

Here, the second parameter may be obtained when fitting the preset model and stored in the memory device.

In some implementations, if M is equal to 2, N is equal to 1, and two reference read voltages and coordinates corresponding to the two first results are substituted into a calculation formula (1) of b, in order to obtain b and to obtain a set of prediction parameters. The prediction parameters is used as the predicted reference voltage.

In some implementations, if M is greater than 2, N is equal to $C_M^2$, and $C_M^2$ combinations of two reference read voltages and their corresponding two first results may be obtained based on M reference read voltages and M first results. $C_M^2$ sets of prediction parameters may be obtained based on the $C_M^2$ combinations in combination with calculation formula (1) of b. Determine outliers of the $C_M^2$ sets of prediction parameters; and determine an outlier based on the median and the standard deviation of the $C_M^2$ sets of prediction parameters, or use both the maximum value and the minimum value of the $C_M^2$ sets of prediction parameters as outliers. After the outliers are removed from the $C_M^2$ sets of prediction parameters, use the median or the average value of the remaining prediction parameters as the predicted reference voltage.

As such, by determining outliers of the plurality of sets of prediction parameters and removing the outliers, the accuracy and reliability is ensured in using the remaining prediction parameters to determine predicted reference voltage.

In some examples, both the first parameter and the second parameter are variables. The memory controller is configured to: obtain a prediction parameter according to the M first results and the M reference read voltages in combination with the quadratic function model; use the prediction parameter as the target read voltage, and obtain a first result of the physical page corresponding to the prediction parameter being used as the target read voltage; obtain a new prediction parameter according to the M first results, the M reference read voltages, the prediction parameter, the first result corresponding to the prediction parameter as the target read voltage in combination with the quadratic function model; and use the new prediction parameter as the predicted reference voltage.

In some implementations, the second parameter is a variable, but an initial value of the second parameter may be obtained when fitting the preset model, and stored in the memory device.

For example, the N sets of prediction parameters are obtained according to the M first results, the M reference read voltages, the quadratic function model, the initial value of the second parameter in combination with the calculation formula (1) of b, where N is equal to $C_M^2$.

In some implementations, if M is equal to 2, N is equal to 1, the two reference read voltages and the coordinates corresponding to the two first results are substituted into the calculation formula (1) of b, in order to obtain b, and then to obtain a set of prediction parameters; the prediction parameters are used as the target read voltage, the first result of the physical page corresponding to the prediction parameters being used as the target read voltages is obtained, that is, one actual point is obtained at this time; next, the coordinates of the 3 actual points (the two reference read voltages and their two corresponding first results, the prediction parameters, and the first result corresponding to the prediction parameters being used as the target read voltages) are substituted into the calculation formula (3) of b, to obtain b, and then to obtain a new set of prediction parameters, and the new prediction parameters are used as the prediction reference voltage.

In this way, the new prediction parameter is further obtained by using the prediction parameter and the first result corresponding to the prediction parameter as the read voltage, so that the accuracy of the obtained predicted reference voltage can be improved.

In some implementations, the M reference read voltages are on the same side of the axis of symmetry of the curve where the quadratic function model is located, for example, the M reference read voltages are all at the first side of the axis of symmetry of the curve where the quadratic function model is located, or the M reference read voltages are all on the second side of the axis of symmetry of the curve where the quadratic function model is located.

In some implementations, at least two of the M reference read voltages are on two sides of the axis of symmetry of the curve where the quadratic function model is located. The points located on two sides of the axis of symmetry of the curve where the quadratic function model is located are more representative, so that a wider data range can be covered, and the accuracy and reliability of determining the prediction parameters according to the reference read voltage to further obtain the predicted reference voltage can be improved.

The process of obtaining the target reference voltage of the physical page by using the preset model and the first parameter thereof is applicable to the first physical page and the second physical page.

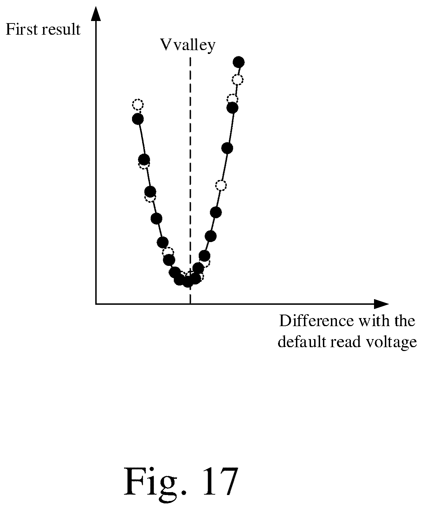

For example, as shown in FIG. 17, the offset value corresponding to the default read voltage is 0. The difference between the target read voltage and the default read voltage is used as the abscissa, the first result corresponding to the target read voltage is used as the ordinate, and the abscissa and the ordinate form a point. The point of the target reference voltage is the point corresponding to the target reference voltage as the abscissa. The hollow point in FIG. 17 is the actual point formed by the target read voltage corresponding to the second level read voltage L2 shown in FIG. 7B and the corresponding first result. The solid point in FIG. 17 is the point on the curve where the preset model (for example, the quadratic function model) is located, the preset model corresponding to the second level read voltage L2 shown in FIG. 7B. As shown in FIG. 17, the actual target reference voltage (Vvalley) almost coincides with the lowest point on the curve where the preset model is located, indicating that the accuracy of determining the target reference voltage by using the preset model in the examples of the present disclosure is high.

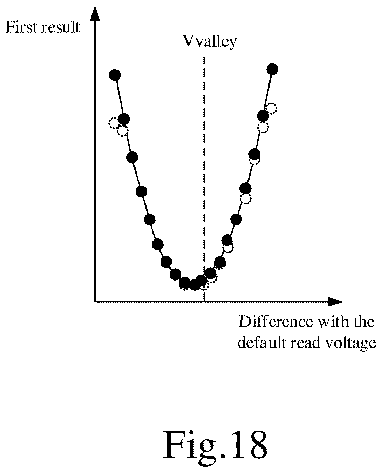

For example, as shown in FIG. 18, the offset value corresponding to the default read voltage is 0. The difference between the target read voltage and the default read voltage is used as the abscissa, the first result corresponding to the target read voltage is used as the ordinate, and the abscissa and the ordinate form a point. The point of the target reference voltage is the point corresponding to the target reference voltage as the abscissa. The hollow point in FIG. 18 is the actual point formed by the target read voltage corresponding to the fourth level read voltage L4 and its corresponding first result as shown in FIG. 7B. The solid point in FIG. 18 is the point on the curve where the preset model (for example, the quadratic function model) is located, the preset model corresponding to the fourth level read voltage L4 shown in FIG. 7B. It can be seen from FIG. 18 that the actual target reference voltage (Vvalley) almost coincides with the lowest point on the curve where the preset model is located.

According to a first aspect, an example of the present disclosure samples data of a first physical page in a memory block by using a read scrub operation, generates a first parameter of a second physical page by obtaining a first parameter of the first physical page, and stores the first parameter of the first physical page and the first parameter of the second physical page. Through the read result of the read scrub operation, the first parameter is dynamically adjusted and the target reference voltage of the physical page is further obtained, so the accuracy of read data is improved. Meanwhile the read retry operation, the error correction rewriting operation and the garbage collection operation in the read scrub operation are reduced, the writing amplification effect is reduced, and the efficiency of the read scrub is significantly improved.

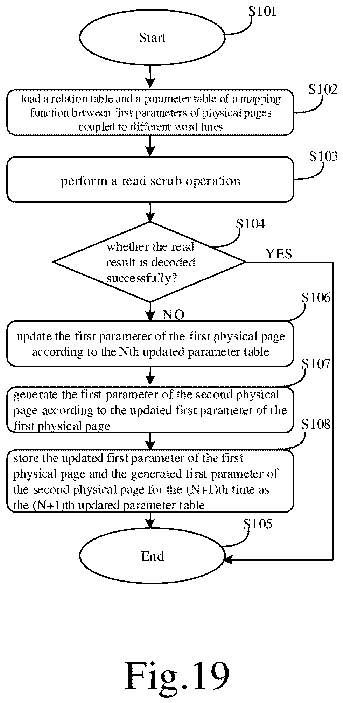

FIG. 19 is a flowchart of a method for operating a memory system according to an example of the present disclosure. The detailed process of performing the read scrub operation will be described in detail below with reference to FIG. 19.

In step S101, a relation table and a parameter table of the mapping function between the first parameters of the physical pages coupled to different word lines are established, and an initial mapping table and an initial parameter table of the relationship between the first parameters of the physical pages coupled to different word lines are established before the read scrub operation is performed for the first time.

After the memory system is powered on, step S102 is performed. A relation table representing a mapping function between first parameters of physical pages coupled to different word lines and a Nth updated parameter table are loaded from the memory device. Taking N equal to 1 as an example, after the memory system is powered on, the initial mapping table representing the relationship between the first parameters of the physical pages coupled to the different word lines and the first updated parameter table (the initial parameter table) are loaded from the memory device.

In step S103, a read scrub operation is performed. The read scrub operation performed during power-on of the memory system does not need to traverse all physical pages in one memory block. In other words, the read scrub operation may be performed in a sampling read scrub manner. For example, when performing the read scrub operation on a memory block, a read result of at least one physical page in the memory block is obtained, where the first physical page in the memory block is a target physical page of the read scrub operation in the plurality of physical pages, and the second physical page is another physical page other than the first physical page of the plurality of physical pages.

Next, step S104 is performed to determine whether the read result obtained by the read scrub operation is decoded successfully.

It should be noted that the condition to determine the failure of decoding the read result is that the fail bit count of the read result is less than or equal to the third preset threshold, where the third preset threshold may be less than or equal to the first preset threshold. It can be understood that, in the process of performing the read scrub operation, when the fail bit count of the obtained read result is lower than or equal to the error correction early warning value of the data of the memory cell, the parameter table is updated to obtain the target reference voltage to improve the correctness of the read data, avoid further expansion of the error or losing data, thereby ensuring dynamic adjustment of the parameter table when the errors in data have not yet resulted in serious impact, and avoiding triggering a read retry operation or an error correction rewriting operation.

If the determination result in step S 104 is yes, step S105 is performed to end the read scrub operation on the current memory block. It may be understood that the determination result of step S104 is that the read result obtained by the read scrub operation is successfully decoded, meaning that no abnormalities were found in the read scrub operation on the current memory block, and the read scrub operation on the current memory block may be ended.

If the determination result of step S104 is no, step S106 is performed to update the first parameter of the first physical page according to the Nth updated parameter table. For example, if the read results are not decoded successfully, the first parameter of the first physical page is updated based on the first parameter of the first physical page stored in the Nth updated parameter table.

Next, step S107 is performed to generate the first parameter of the second physical page according to the updated first parameter of the first physical page. For example, reference may be made to the related description of obtaining the target reference voltage of the physical page according to the preset model and the first parameter thereof and updating the first parameter in the foregoing example, and details are not described herein again.

Next, step S108 is performed to store the updated first parameter of the first physical page and the generated first parameter of the second physical page for the (N+1)th time as the (N + 1)th updated parameter table, where N is a positive integer.

In step S105, the read scrub operation on the current memory block ends.

It should be noted that, during power-on of the memory system, the read scrub operation periodically performed includes read scrub operations on different memory blocks. FIG. 19 illustrates a process of performing a read scrub operation on one of the plurality of memory blocks as an example. After step S105, read scrub operations may continue to be performed on the remaining memory blocks.

It should be noted that, after the step S105 in the example of the present disclosure, the data migration operation or the garbage collection operation may be avoided, because the failure of decoding the read result of the first physical page obtained by the read scrub operation does not mean that the data itself is not recoverable, but it may be considered that the read condition used is inappropriate. By dynamically updating the first parameter and obtaining the target reference voltage of the physical page according to the preset model and the first parameter in the foregoing example, so as to perform a subsequent read operation or a read scrub operation, that is, to optimize the read voltage to successfully read the data, thereby avoiding unnecessary read retry operations, data migration operations, and garbage collection operations.

Herein, the read result of the first physical page obtained in the read scrub operation still uses the fail bit count reaching a certain threshold (the third preset threshold) as the triggering condition, but when the decoding of the read result of the first physical page obtained in the read scrub operation fails, the read retry operation or the data migration operation is not immediately performed, but instead the first parameter of each physical page is dynamically updated to generate the target reference voltage in the subsequent read operation or the read scrub operation, that is, the threshold voltage offset of each physical page in the memory block is obtained, so that the read condition can be changed without performing the read retry operation or the data migration operation, so as to improve the success rate and accuracy of data read, so that the read scrub operation can be more rapid and efficient, the performance of the memory system is optimized, and the service life of the memory system is prolonged.

In some examples, the third preset threshold is set to be less than or equal to the first preset threshold. In this way, it can be ensured that the data is processed in time before the data is completely unrecoverable or seriously damaged.

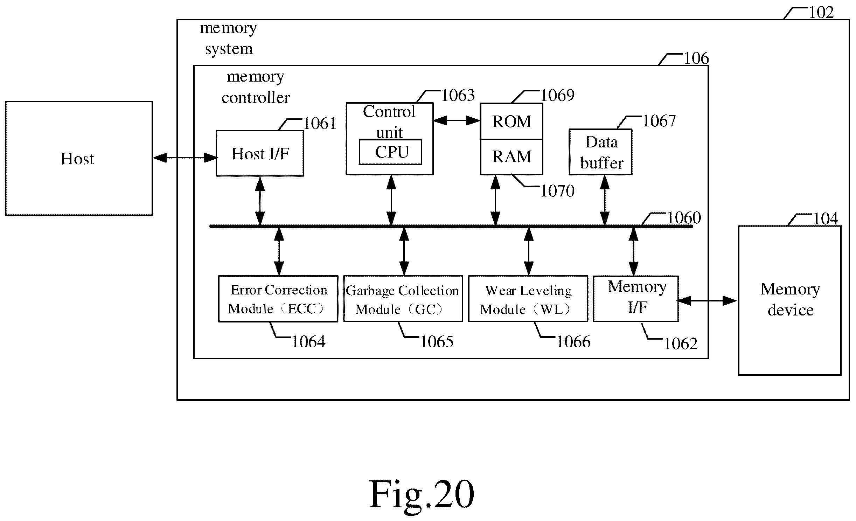

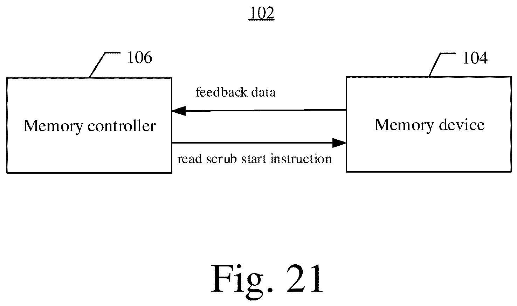

In some examples, as shown in Fig. 20 and Fig. 21, the memory system 102 includes one or more memory devices 104; and a memory controller 106 coupled to the memory device 104 and controlling the memory device 104.

As shown in FIG. 20, in some examples, the memory system 102 is coupled to a host, and performs various feedback in response to an instruction of the host. The memory system 102 may include a memory controller 106 and a memory device 104, the memory controller 106 is configured to control the memory device 104 to perform operations such as read / write erase, and the memory controller 106 and the memory device 104 may be coupled in any suitable manner.

The memory controller 106 may include a host interface (I/F) 1061, a memory interface (I/F) 1062, a control unit 1063, a read-only memory (ROM) 1069, a random access memory (RAM) 1070, an error correction module 1064, a garbage collection module 1065, a wear leveling module 1066, a data buffer 1067, and a bus 1060. The host interface 1061 is a connection interface connecting the host 108 and the memory controller 106, and the host interface 1061 allows the host and the memory controller to communicate according to a specific protocol, send read and write requests, and perform other operations. The memory interface 1062 is a connection interface between the memory controller 106 and the memory device 104, and the memory interface 1062 is configured to implement data transmission between the memory controller 106 and the memory device 104. The control unit 1063 is configured to control the memory controller 106 as a whole, and the specific steps performed by the memory controller are mainly performed and completed by the control unit 1063 herein. In some examples, the control unit 1063 is, for example, a central processing unit (CPU), a microprocessor (MCU), or the like. ROM 1069 typically contains firmware or firmware program code of memory controller 106 for initializing and operating various components of a memory controller, and RAM 1070 is typically configured to buffer data. The error correction module 1064 may further include an encoding unit and a decoding unit; the encoding unit is configured to encode the data to be stored to obtain check data, and the decoding unit is configured to decode the check data to detect and correct possible error data in a data transmission process.

The garbage collection module 1065 is configured to read out valid data on some memory blocks after the storage space of the memory device reaches a certain threshold, rewrite and then mark the memory blocks to obtain new backup memory blocks. The general implementation of garbage collection can be divided into three steps: selecting a source memory block with not too much valid data; finding valid data from the source memory block; and writing the valid data to the target memory block. In this case, all data in the source memory block becomes invalid data, and the source memory block is marked and can be used as a new backup memory block. The wear leveling module 1066 is configured to use data statistics and algorithms to keep wear (erase counts) of each memory block in the memory system to be balanced. The general implementation of wear leveling can be divided into two steps: selecting a source memory block where cold data is located; reading valid data on the source memory block and writing it to a memory block with a relatively large erase count, in this case, valid data in the source memory block becomes invalid data and is marked. The data buffer 1067 is configured to buffer data.

According to a second aspect, an example of the present disclosure provides a memory controller coupled to at least one memory device, where the memory device includes a plurality of word lines; each word line is coupled to a plurality of memory cells, and a plurality of memory cells coupled to a same word line form at least one physical page; the memory controller includes an interface, a buffer, and a control unit; wherein the control unit is configured to: obtain a first parameter of a first physical page of a plurality of physical pages according to data fed back by the memory device, the first parameter is a parameter in a preset model for generating a target reference voltage, and the target reference voltage is used as a read voltage of the physical page when performing a read operation; the plurality of physical pages include the first physical page and a second physical page, the first physical page is a target physical page of the read scrub operation in the plurality of physical pages, and the second physical page is another physical page other than the first physical page of the plurality of physical pages; generate a first parameter of the second physical page according to the first parameter of the first physical page in combination with a location relationship between the second physical page and the first physical page; and store, by the buffer, the first parameter of the first physical page and the first parameter of the second physical page.

The steps performed by the memory controller are mainly performed and completed by the control unit 1063 in FIG. 20. The interface of the memory controller may be understood with reference to the memory interface 1062 in FIG. 20, and the buffer of the memory controller may be understood with reference to the RAM 1070 in FIG. 20.

In some examples, the control unit is configured to: according to the data fed back by the memory device, send a read scrub start instruction to the memory device through the interface before obtaining the first parameter of the at least one physical page in the plurality of physical pages.

For example, as shown in FIG. 21, the control unit of the memory controller 106 sends, according to the data fed back by the memory device 104, a read scrub start instruction to the memory device 104 before obtaining the first parameter of the at least one physical page in the plurality of physical pages.

In some examples, the control unit is configured to: generate a first parameter of the second physical page according to the first parameter of the first physical page, a location relationship between the second physical page and the first physical page in combination with a mapping function, where the mapping function represents a relationship between first parameters of the plurality of physical pages.

In some examples, a number of memory bits of the memory cell is P bits, and P memory bits correspond to $2^P -1$ levels of read voltages; where P is an integer greater than or equal to 1; and the mapping function includes $2^P -1$ first mapping functions corresponding to $2^P -1$ levels of read voltages respectively.

In some examples, the plurality of word lines includes Q word line groups, the first mapping function includes Q second mapping functions corresponding to the Q word line groups respectively; a relationship between first parameters of the physical pages coupled to each word line in a same word line group conforms to a corresponding second mapping function, where Q is an integer greater than or equal to 1; and the control unit is configured to: when obtaining the first parameter of the first physical page, obtain a first parameter of a physical page coupled to at least one word line in each word line group of the Q word line groups.

In some examples, the control unit is configured to: during a read operation after performing a read scrub operation, obtain a target reference voltage of at least one of the second physical pages based on a plurality of first parameters of the second physical pages stored in the buffer; and perform the read operation on the at least one of the second physical pages according to the obtained target reference voltage of the at least one of the second physical pages.

In some examples, the Nth updated parameter table includes the Nth stored first parameter of the first physical page and the first parameter of the second physical page; the control unit is configured to: obtain a read result of the plurality of first physical pages from the memory device through the interface; update a first parameter of the first physical page based on the first parameter of the first physical page stored in the Nth updated mapping table if the read results are not decoded successfully; and generate a first parameter of the second physical page according to the updated first parameter of the first physical page; and store the updated first parameter of the first physical page and the generated first parameter of the second physical page for the (N + 1) th time as the (N + 1) th updated parameter table; N is a positive integer.

In some examples, the control unit is configured to: in response to the memory controller being powered on, load a relation table representing the mapping function and the Nth updated parameter table from the memory device; and in response to the memory controller being powered off, store the (N + 1) updated parameter table in the memory device.

In some examples, the preset model is a quadratic function model, and the first parameter is a curvature of a curve where the quadratic function model is located.

In some examples, the control unit is configured to: obtain M first results of the physical page corresponding to M reference read voltages; the first result includes a number of bits flipped in two read results of the physical page under a first read voltage and a second read voltage; a difference between the first read voltage and the second read voltage is less than a preset voltage; M is an integer greater than or equal to 2; obtain a predicted reference voltage according to the M first results and the M reference read voltages in combination with the quadratic function model and a first parameter in the Nth updated mapping table; the quadratic function model represents a relationship between the first result and the reference read voltage; the M first results are all within a first preset interval; and determine a target reference voltage and a first parameter in an (N + 1)th updated parameter table based on the predicted reference voltage.

According to a second aspect, an example of the present disclosure samples data of a first physical page in a memory block by using a read scrub operation, generates a first parameter of a second physical page by obtaining a first parameter of the first physical page, and stores the first parameter of the first physical page and the first parameter of the second physical page. The first parameter is dynamically adjusted through the read result of the read scrub operation and the target reference voltage of the physical page is further obtained, the accuracy of read data is improved while the read retry operation, the error correction rewriting operation and the garbage collection operation in the read scrub operation are reduced, the writing amplification effect is reduced, and the efficiency of the read scrub is significantly improved.

According to a third aspect, an example of the present disclosure provides an operation method of a memory system, the operation method includes:

in a process of performing a read scrub operation, obtaining a first parameter of a first physical page of a plurality of physical pages, the first parameter is a parameter in a preset model for generating the target reference voltage, and the target reference voltage is used as a read voltage of the physical page when performing a read operation; the memory system includes at least one memory device, and the memory device includes a plurality of word lines; each word line is coupled to a plurality of memory cells, and the plurality of memory cells coupled to a same word line form at least one physical page; the plurality of physical pages include the first physical page and a second physical page, the first physical page is at least one physical page performing the read scrub operation, and the second physical page is another physical page other than the first physical page of the plurality of physical pages;

generating a first parameter of the second physical page according to the first parameter of the first physical page in combination with a location relationship between the second physical page and the first physical page; storing the first parameter of the first physical page and the first parameter of the second physical page.

In some examples, the operation method of the memory system includes: generating a first parameter of the second physical page according to the first parameter of the first physical page, a location relationship between the second physical page and the first physical page in combination with a mapping function, where the mapping function represents a relationship between first parameters of the plurality of physical pages.

In some examples, a number of memory bits of the memory cell is P bits, and P memory bits correspond to $2^P$ -1 levels of read voltages; where P is an integer greater than or equal to 1; and the mapping function includes $2^P$ -1 first mapping functions corresponding to $2^P$ -1 levels of read voltages respectively.

In some examples, the plurality of word lines includes Q word line groups, the first mapping function includes Q second mapping functions corresponding to the Q word line groups respectively; a relationship between first parameters of the physical pages coupled to each word line in a same word line group conforms to a corresponding second mapping function, where Q is an integer greater than or equal to 1; and the operation method of the memory system includes: when obtaining the first parameter of the first physical page, obtain a first parameter of a physical page coupled to at least one word line in each word line group of the Q word line groups.

In some examples, the operation method of the memory system includes: during a read operation after performing a read scrub operation, obtaining a target reference voltage of at least one of the second physical pages based on the stored first parameter of the second physical page; and perform the read operation on the at least one of the second physical pages according to the obtained target reference voltage of the at least one of the second physical pages.

In some examples, the Nth updated parameter table includes the Nth stored first parameter of the first physical page and the first parameter of the second physical page; and the operation method of the memory system includes: in the process of performing the read scrub operation, obtaining a read result of the first physical page; update a first parameter of the first physical page based on the first parameter of the first physical page stored in the Nth updated mapping table if the read results are not decoded successfully; and generating a first parameter of the second physical page according to the updated first parameter of the first physical page; and storing the updated first parameter of the first physical page and the generated first parameter of the second physical page for the (N + 1) th time as the (N + 1) th updated parameter table; N is a positive integer.

In some examples, the operation method of the memory system includes: in response to the memory system being powered on, loading a relation table representing the mapping function and the Nth updated parameter table from the memory device; and in response to the memory system being powered off, store the (N + 1) updated parameter table in the memory device.

In some examples, the preset model is a quadratic function model, and the first parameter is a curvature of a curve where the quadratic function model is located.

In some examples, the operation method of the memory system includes: obtaining M first results of the physical page corresponding to M reference read voltages; the first result includes a number of bits flipped in two read results of the physical page under a first read voltage and a second read voltage; a difference between the first read voltage and the second read voltage is less than a preset voltage; M is an integer greater than or equal to 2; obtain a predicted reference voltage according to the M first results and the M reference read voltages in combination with the quadratic function model and a first parameter in the Nth updated mapping table; the quadratic function model represents a relationship between the first result and the reference read voltage; the M first results are all within a first preset interval; and determine a target reference voltage and a first parameter in an (N + 1)th updated parameter table based on the predicted reference voltage.

In some examples, the first preset interval represents a range between a first threshold and a second threshold of a curve where the quadratic function model is located; the first threshold is greater than the second threshold.

In some examples, the operation method of the memory system includes: obtaining a first result of the physical page corresponding to a target read voltage; and according to the first result of the physical page corresponding to the target read voltage being within the first preset interval, using the target read voltage as the reference read voltage, and using the first result in the first preset interval as a first result corresponding to the reference read voltage.

In some examples, the operation method of the memory system includes: obtaining a prediction parameter of the quadratic function model according to the M first results and the M reference read voltages in combination with the quadratic function model; the prediction parameter is a corresponding reference read voltage when a first result in a curve where the quadratic function model is located is minimum; obtaining the predicted reference voltage according to the prediction parameter; and determining the target reference voltage and a first parameter in the (N + 1) th updated parameter table based on the predicted reference voltage.

In some examples, the operation method of the memory system includes: obtaining a first result of the physical page corresponding to a target read voltage; and using the target read voltage as the reference read voltage according to the first result of the physical page corresponding to the target read voltage being within the first preset interval; re-obtaining at least one new target read voltage according to the first result of the physical page corresponding to the target read voltage being outside the first preset interval; and obtaining a first result corresponding to the at least one new target read voltage until the first result corresponding to the newest target read voltage is within the first preset interval.

In some examples, at least two of the M reference read voltages are at two sides of an axis of symmetry of a curve where the quadratic function model is located; the operation method of the memory system includes: obtaining a reference read voltage at a first side of two sides of the axis of symmetry of the curve in which the quadratic function model is located when obtaining the reference read voltage; and determining a reference read voltage at a second side of two sides of the axis of symmetry according to the reference read voltage at the first side.

The example of the present disclosure further provides an operation method of a memory controller, the memory controller is coupled to at least one memory device, and the memory device includes a plurality of word lines; each word line is coupled to a plurality of memory cells, and a plurality of memory cells coupled to the same word line form at least one physical page; the operation method includes the following steps: sending a read scrub start instruction to the memory device through an interface of the memory controller; obtaining a first parameter of a first physical page of a plurality of physical pages according to the data fed back by the memory device, wherein the first parameter is a parameter in a preset model for generating a target reference voltage, and the target reference voltage is used as a read voltage of the physical page when performing the read operation; generating a first parameter of a second physical page according to the first parameter of the first physical page in combination with a location relationship between the second physical page and the first physical page; and storing, by a buffer of the memory controller, the first parameter of the first physical page and the first parameter of the second physical page.

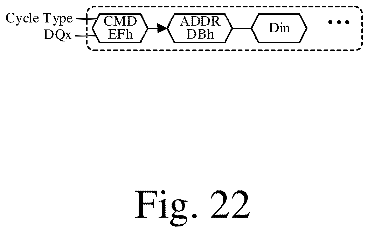

FIG. 22 is a timing diagram of an exemplary startup single-level read mode operation according to the present disclosure. DQx may represent a data bus signal, and Cycle Type may further represent the type of data bus signal.

As shown in FIG. 22, the setting function command may include, for example, a sub-command (for example, EFh), for example, the memory device starts the single-level read mode in the received sub-command EFh. In the single-level read mode, the memory device transmits an address ADDR (e.g., two column addresses C1-C2 and three row addresses R1-R3) of data to be read between the received sub-commands 00h and 30h. During the read time, the corresponding data DATA (e.g., Dn) in the page receiving the address may be buffered in the page buffer and then may be read as needed. It should be noted that, in the foregoing example, when data (for example, Dn) corresponding to one

**EP 4 712 080 A1**

physical page needs to be frequently transmitted (Din / Dout) between the memory device and the memory controller when performing the read retry operation, the time spent on transmitting the data is long.

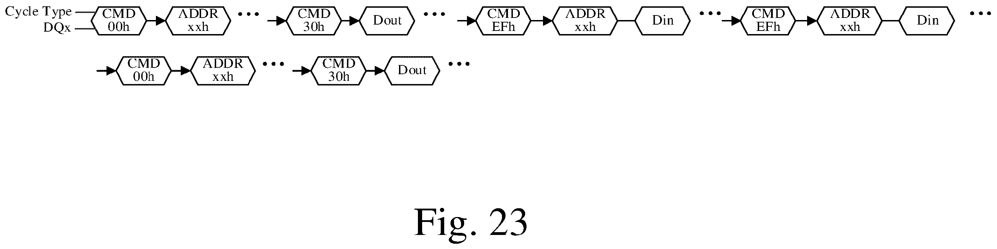

FIG. 23 is a timing diagram of performing a read scrub operation according to an example of the present disclosure. As shown in FIG. 23, the read command may include, for example, two sub-commands (e.g., 00h and 30h), for example, the memory device transmits an address ADDR (e.g., two column addresses C1-C2 and three row addresses R1-R3) of data to be read between the received sub-commands 00h and 30h. After the memory device receives the sub-command 30h, in the read time, the corresponding data DATA (e.g., Dn) in the page receiving the address may be buffered in the page buffer and then may be read as needed.

In an exemplary implementation, the memory device 104 transmits an address ADDR (e.g., two column addresses C1-C2 and three row addresses R1-R3) of data to be read between the received sub-commands 00h and 30h. After the memory device 104 receives the sub-command 30h, the sub-commands EFh and xxh of the read scrub start instruction are received, the memory device 104 obtains the read result of the partial physical page under the instruction of the read scrub start instruction, and feeds back the data to the memory controller. It should be noted that the feedback data may be a fail bit count of the read result of the partial physical page obtained by the read scrub operation. The memory controller obtains a first parameter of a first physical page of a plurality of physical pages according to feedback data received from the memory device, wherein the first parameter is a parameter in a preset model for generating a target reference voltage, and the target reference voltage is used as a read voltage of the physical page when the read operation is performed; the plurality of physical pages comprise a first physical page and a second physical page, the first physical page is at least one physical page performing a read scrub operation, and the second physical page is another physical page other than the first physical page of the plurality of physical pages; generating a first parameter of the second physical page according to the first parameter of the first physical page in combination with a location relationship between the second physical page and the first physical page,; and storing the first parameter of the first physical page and the first parameter of the second physical page.

It should be noted that the read scrub start instruction provided in this example of the present disclosure is merely an example, and should not limit the protection scope of the present disclosure.

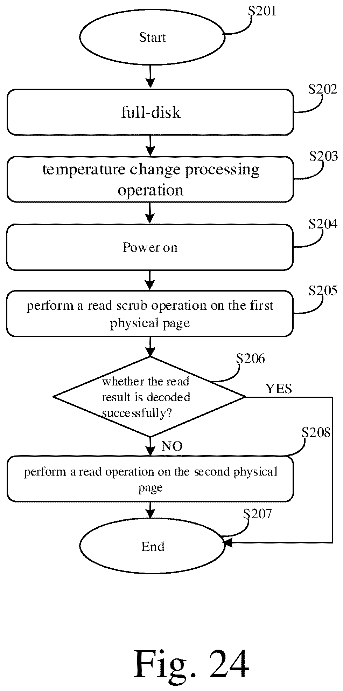

In some examples, as shown in FIG. 24, a process of performing a read scrub operation is verified by using an operation method of a memory system according to an example of the present disclosure.

In step S201, a relation table and a parameter table of the mapping function between the first parameters of the physical pages coupled to different word lines are established. Next, step S202 is performed.

In step S202, full-disk operation is performed, that is, full data is written into the SSD to be tested. Next, step S203 is performed.

In step S203, a temperature change processing operation is performed. For example, in order to accelerate the speed of weakening of data retention capacity of the SSD to be tested, the SSD to be tested is heated, for example, the SSD to be tested is heated to a preset temperature threshold by using a temperature change device. Here, the preset temperature threshold is less than the upper limit of holding temperature specified by the SSD.

Next, step S204 is performed to power on the SSD to be tested. When the SSD to be tested is powered on, a relation table representing the mapping function between the first parameters of the physical pages coupled to different word lines and the Nth updated parameter table are loaded from the memory device. Taking N equal to 1 as an example, after the SSD to be tested is powered on, the initial mapping table representing the relationship between the first parameters of the physical pages coupled to different word lines and the first updated parameter table (the initial parameter table) are loaded from the memory device.

Next, step S205 is performed to perform a read scrub operation on the first physical page. It should be noted that the read scrub operation does not need to traverse all physical pages in one memory block, that is, the read scrub operation may be performed in a sampling read scrub manner, for example, when a read scrub operation is performed on a memory block, a read result of at least one physical page in the memory block is obtained, where the first physical page in the memory block is a target physical page of the read scrub operation in the plurality of physical pages, and the second physical page is another physical page other than the first physical page of the plurality of physical pages.

Next, step S206 is performed to determine whether the read result obtained by the read scrub operation is decoded successfully.

If the determination result of step S206 is yes, step S207 is performed, and the operation ends.

If the determination result of step S206 is no, step S208 is performed to perform a read operation on the second physical page. It should be noted that, before the step S208 is performed, the first parameter of the first physical page is updated based on the first parameter of the first physical page stored in the Nth updated parameter table if the read results are not decoded successfully. The first parameter of the second physical page is further generated according to the updated first parameter of the first physical page. The updated first parameter of the first physical page and the generated first parameter of the second physical page are stored for the (N + 1) times as the (N+1)th updated parameter table. For example, reference may be made to the related description of obtaining the target reference voltage of the physical page according to the preset model and the first parameter thereof and updating the first parameter in the foregoing example, and details are not described herein again.

Here, in the example of the present disclosure, the temperature change processing operation is performed on the SSD to be tested before the SSD to be tested is powered on to accelerate the weakening of the data retention capacity, so that during the temperature change processing operation, the threshold voltage of the memory cell in the SSD to be tested can be shifted by controlling the duration of the SSD to be tested at the preset temperature threshold, so that when the determination result of step S206 is no, the operation method provided by the example of the present disclosure can update the first parameter of the first physical page and the first parameter of the second physical page, and further obtain the target reference voltage of the second physical page according to the updated first parameter, so as to improve the accuracy of performing the read operation on the second physical page on which the read scrub operation is not performed.

It may be understood that, in the example of the present disclosure, in step S208, the read operation is performed on the second physical page according to the target reference voltage obtained by the updated first parameter of the second physical page, and the obtained read result is successfully decoded.

Next, step S207 is performed, and the operation ends.

An example of the present disclosure further provides a storage medium, where the storage medium stores executable instructions, and when the executable instructions are executed, the steps of the operation method in the foregoing examples of the present disclosure may be implemented.

In some examples, the storage medium may be a magnetic random access memory (FRAM), a read-only memory (ROM), a programmable read-only memory (PROM), an erasable programmable read-only memory (EPROM), an electrically erasable programmable read-only memory (EEPROM), a flash memory, a magnetic surface memory, an optical disk, or a compact disc read-only memory (CD-ROM), or the like; or may be various devices including one or any combination of the foregoing memory devices.

In some examples, the executable instructions may be written in the form of a program, software, software module, script, or code, may be written in any form of programming language (including compiled or interpreted languages, or declarative or procedural languages), and may be deployed in any form, including being deployed as a standalone program or as a module, component, subroutine, or other unit suitable for use in a computing environment.

As an example, executable instructions may, but need not, correspond to files in a file system, may be stored in a portion of a file that stores other programs or data, for example, in one or more scripts stored in a hypertext markup language (HTML) document, in a single file dedicated to the program in question, or in multiple collaborative files (e.g., files that store one or more modules, subroutines, or portions of code).

As an example, executable instructions may be deployed for execution on one electronic device, or on multiple electronic devices located at one place, or alternatively on multiple electronic devices distributed at multiple places and interconnected by a communication network.

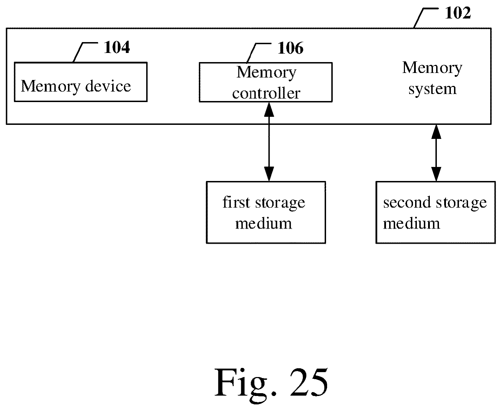

In some examples, referring to FIG. 25, FIG. 25 is a schematic diagram of a composition structure of a storage medium according to an example of the present disclosure, where the storage medium includes a first storage medium corresponding to the memory controller 106 and a second storage medium corresponding to the memory system 102; when the executable instruction is executed by the memory controller, the first storage medium may be configured to implement steps of the operation method of the memory controller in the foregoing examples of the present disclosure; and when the executable instruction is executed by the memory system, the second storage medium may be configured to implement steps of the operation method of the memory system in the foregoing examples of the present disclosure.

It should be understood that "one example" or "an example" mentioned throughout the specification means that a specific feature, structure, or characteristic related to the example is included in at least one example of the present disclosure. Thus, "in one example" or "in an example" appearing throughout the specification need not necessarily refer to the same example. Further, these particular features, structures, or characteristics may be incorporated in one or more examples in any suitable manner. It should be understood that, in various examples of the present disclosure, the sequence numbers of the foregoing processes do not mean a sequence of execution sequences, and an execution sequence of each process should be determined by function and intrinsic logic thereof, and should not constitute any limitation on an implementation process of the examples of the present disclosure. The foregoing sequence numbers of the examples of the present disclosure are merely for description, and do not represent the advantages or disadvantages of the examples.

The above description is only an example implementation of the present disclosure, and is not intended to limit the scope of the present disclosure, and any equivalent structural transformation made by using the present disclosure and the accompanying drawings or any direct/indirect application of the present disclosure to other related technical fields is included within the scope of the present disclosure.

**Claims**

1. A memory system, including:

    a memory device including a plurality of word lines, wherein each word line is coupled to a plurality of memory cells, and the plurality of memory cells coupled to a same word line form at least one physical page;
    a memory controller coupled to the memory device and configured to:

        when performing a read scrub operation, obtain a first parameter of a first physical page of a plurality of physical pages, wherein the first parameter is a parameter in a preset model for generating a target reference voltage, and the target reference voltage is used as a read voltage of the physical page when performing a read operation, and wherein the plurality of physical pages includes the first physical page and a second physical page, the first physical page is a target physical page of the read scrub operation in the plurality of physical pages, and the second physical page is another physical page other than the first physical page of the plurality of physical pages; and generate a first parameter of the second physical page according to the first parameter of the first physical page in combination with a location relationship between the second physical page and the first physical page; and
        store the first parameter of the first physical page and the first parameter of the second physical page.

2. The memory system of claim 1, wherein the memory controller is configured to:
    generate the first parameter of the second physical page according to the first parameter of the first physical page, the location relationship between the second physical page and the first physical page in combination with a mapping function, wherein the mapping function represents a relationship between the first parameters of the plurality of physical pages.

3. The memory system of claim 2, wherein a number of memory bits of the memory cell is P bits, and P memory bits correspond to $2^P$ -1 levels of read voltages, wherein P is an integer greater than or equal to 1, and the mapping function includes $2^P$ -1 first mapping functions corresponding to the $2^P$ -1 levels of read voltages respectively.

4. The memory system of claim 3, wherein the plurality of word lines includes Q word line groups, the first mapping function includes Q second mapping functions corresponding to the Q word line groups respectively, and a relationship between the first parameters of the physical pages coupled to each word line in a same word line group conforms to the corresponding second mapping function, wherein Q is an integer greater than or equal to 1; and
    the memory controller is configured to:
    when obtaining the first parameter of the first physical page, obtain the first parameter of a physical page coupled to at least one word line in each word line group of the Q word line groups.

5. The memory system of claim 1, wherein the memory controller is configured to:

        during a read operation after performing a read scrub operation, obtain a target reference voltage of at least one of the second physical pages based on the stored first parameters of the second physical pages; and
        perform the read operation on the at least one of the second physical pages according to the obtained target reference voltage of the at least one of the second physical pages.

6. The memory system of claim 1, wherein a Nth updated parameter table includes the first parameter of the first physical page and the first parameter of the second physical page being stored for the Nth time;
    the memory controller is configured to:

        when performing the read scrub operation, obtain read results of the first physical page;
        if the read results are not decoded successfully, update the first parameter of the first physical page based on the first parameter of the first physical page stored in the Nth updated parameter table, and generate the first parameter of the second physical page according to the updated first parameter of the first physical page; and
        store the updated first parameter of the first physical page and the generated first parameter of the second physical page for the (N+1)th time as the (N+1)th updated parameter table, wherein N is a positive integer.

7. The memory system of claim 6, wherein the memory controller is configured to:

        in response to the memory system being powered on, load a relation table representing a mapping function and the Nth updated parameter table from the memory device; and

in response to the memory system being powered off, store the (N+1)th updated parameter table in the memory device.

8. The memory system of claim 6, wherein the preset model is a quadratic function model, and the first parameter is a curvature of a curve where the quadratic function model is located.

9. The memory system of claim 8, wherein the memory controller is configured to:

obtain M first results of the physical page corresponding to M reference read voltages, the first result comprising a number of bits flipped between two read results of the physical page under a first read voltage and a second read voltage, wherein a difference between the first read voltage and the second read voltage is less than a preset voltage, and M is an integer greater than or equal to 2;

obtain a predicted reference voltage according to the M first results and the M reference read voltages in combination with the quadratic function model and the first parameter in the Nth updated parameter table, wherein the quadratic function model represents a relationship between the first result and the reference read voltage, and the M first results are all within a first preset interval; and

determine the target reference voltage and the first parameter in the (N + 1)th updated parameter table based on the predicted reference voltage.

10. The memory system of claim 9, wherein the first preset interval represents a range between a first threshold and a second threshold of a curve where the quadratic function model is located, wherein the first threshold is greater than the second threshold.

11. The memory system of claim 9, wherein the memory controller is configured to:

obtain a first result of the physical page corresponding to a target read voltage; and

according to the first result of the physical page corresponding to the target read voltage being within the first preset interval, use the target read voltage as the reference read voltage, and use the first result within the first preset interval as a first result corresponding to the reference read voltage.

12. The memory system of claim 9, wherein the memory controller is configured to:

obtain a prediction parameter of the quadratic function model according to the M first results and the M reference read voltages in combination with the quadratic function model, wherein the prediction parameter is a corresponding reference read voltage when the first result in a curve where the quadratic function model is located is minimum;

obtain the predicted reference voltage according to the prediction parameter; and

determine the target reference voltage and the first parameter in the (N + 1)th updated parameter table based on the predicted reference voltage.

13. The memory system of claim 10, wherein the memory controller is configured to:

obtain a first result of the physical page corresponding to a target read voltage; and

use the target read voltage as the reference read voltage according to the first result of the physical page corresponding to the target read voltage being within the first preset interval;

re-obtain at least one new target read voltage according to the first result of the physical page corresponding to the target read voltage being outside the first preset interval, and obtain the first result corresponding to the at least one new target read voltage until the first result corresponding to the newest target read voltage is within the first preset interval.

14. The memory system of claim 13, wherein at least two of the M reference read voltages are at two sides of an axis of symmetry of a curve where the quadratic function model is located;

the memory controller is configured to:

obtain a reference read voltage at a first side of two sides of the axis of symmetry of the curve in which the quadratic function model is located when obtaining the reference read voltage; and

determine a reference read voltage at a second side of two sides of the axis of symmetry according to the reference read voltage at the first side.

15. The memory system of claim 1, wherein the memory device comprises a plurality of memory blocks, and the memory block comprises the plurality of physical pages, wherein the first physical page and the second physical page are located in a same memory block.

16. The memory system of claim 9, wherein the memory device is configured to:

read the stored data of the physical page under the first read voltage to obtain a second result;
read the stored data of the physical page under the second read voltage to obtain a third result;
perform a logical operation on the second result and the third result to obtain a fourth result;
count a number of bits in the fourth result representing that bits of the third result are flipped relative to the second result, to obtain the first result.

17. The memory system of claim 16, wherein the memory device comprises: a first latch, a second latch, and a third latch, wherein

the first latch is configured to store the second result;
the second latch is configured to store the third result; and
the third latch is configured to store the fourth result.

18. A memory controller coupled to at least one memory device, the memory device includes a plurality of word lines, wherein each word line is coupled to a plurality of memory cells, and a plurality of memory cells coupled to a same word line form at least one physical page;

the memory controller includes an interface, a buffer, and a control unit, wherein
the control unit is configured to:

according to data fed back by the memory device, obtain a first parameter of a first physical page of a plurality of physical pages, wherein the first parameter is a parameter in a preset model for generating a target reference voltage, and the target reference voltage is used as a read voltage of the physical page when performing a read operation, and wherein the plurality of physical pages includes the first physical page and a second physical page, the first physical page is a target physical page of a read scrub operation in the plurality of physical pages, and the second physical page is another physical page other than the first physical page of the plurality of physical pages; and generate a first parameter of the second physical page according to the first parameter of the first physical page in combination with a location relationship between the second physical page and the first physical page; and
store, by the buffer, the first parameter of the first physical page and the first parameter of the second physical page.

19. The memory controller of claim 18, wherein the control unit is configured to:
before obtaining the first parameter of at least one physical page of the plurality of physical pages according to the data fed back by the memory device, send a read scrub start instruction to the memory device through the interface.

20. The memory controller of claim 18, wherein the control unit is configured to:
generate the first parameter of the second physical page according to the first parameter of the first physical page, the location relationship between the second physical page and the first physical page in combination with a mapping function, wherein the mapping function represents a relationship between the first parameters of the plurality of physical pages.

21. The memory controller of claim 20, wherein a number of memory bits of the memory cell is P bits, and P memory bits correspond to $2^P$ -1 levels of read voltages, wherein P is an integer greater than or equal to 1, and the mapping function includes $2^P$ -1 first mapping functions corresponding to the $2^P$ -1 levels of read voltages respectively.

22. The memory controller of claim 21, wherein the plurality of word lines includes Q word line groups, the first mapping function includes Q second mapping functions corresponding to the Q word line groups respectively, and a relationship between the first parameters of the physical pages coupled to each word line in a same word line group conforms to the corresponding second mapping function, wherein Q is an integer greater than or equal to 1; and
the control unit is configured to:
when obtaining the first parameter of the first physical page, obtain the first parameter of a physical page coupled to at least one word line in each word line group of the Q word line groups.

23. The memory controller of claim 18, wherein the control unit is configured to:

during a read operation after performing a read scrub operation, obtain a target reference voltage of at least one of the second physical pages based on a plurality of first parameters of the second physical pages stored in the buffer; and
perform the read operation on the at least one of the second physical pages according to the obtained target reference voltage of the at least one of the second physical pages.

24. The memory controller of claim 18, wherein a Nth updated parameter table includes the first parameter of the first physical page and the first parameter of the second physical page being stored for the Nth time; and
the control unit is configured to:

obtain read results of a plurality of first physical pages from the memory device through the interface;
if the read results are not decoded successfully, update the first parameter of the first physical page based on the first parameter of the first physical page stored in the Nth updated parameter table, and generate the first parameter of the second physical page according to the updated first parameter of the first physical page; and store the updated first parameter of the first physical page and the generated first parameter of the second physical page for the (N+1)th time as the (N+1)th updated parameter table, wherein N is a positive integer.

25. The memory controller of claim 24, wherein the control unit is configured to:

in response to the memory controller being powered on, load a relation table representing a mapping function and the Nth updated parameter table from the memory device; and
in response to the memory controller being powered off, store the (N+1)th updated parameter table in the memory device.

26. The memory controller of claim 24, wherein the preset model is a quadratic function model, and the first parameter is a curvature of a curve where the quadratic function model is located.

27. The memory controller of claim 26, wherein the control unit is configured to:

obtain M first results of the physical page corresponding to M reference read voltages, the first result comprising a number of bits flipped between two read results of the physical page under a first read voltage and a second read voltage, wherein a difference between the first read voltage and the second read voltage is less than a preset voltage, and M is an integer greater than or equal to 2;
obtain a predicted reference voltage according to the M first results and the M reference read voltages in combination with the quadratic function model and the first parameter in the Nth updated parameter table, wherein the quadratic function model represents a relationship between the first result and the reference read voltage, and the M first results are all within a first preset interval; and
determine the target reference voltage and the first parameter in the (N + 1)th updated parameter table based on the predicted reference voltage.

28. An operation method of a memory system, the operation method includes:

when performing a read scrub operation, obtaining a first parameter of a first physical page of a plurality of physical pages, wherein the first parameter is a parameter in a preset model for generating a target reference voltage, and the target reference voltage is used as a read voltage of the physical page when performing a read operation, and wherein the memory system includes at least one memory device, and the memory device includes a plurality of word lines, wherein each word line is coupled to a plurality of memory cells, and the plurality of memory cells coupled to a same word line form at least one physical page, wherein the plurality of physical pages include the first physical page and a second physical page, the first physical page is at least one physical page performing the read scrub operation, and the second physical page is another physical page other than the first physical page of the plurality of physical pages;

generating the first parameter of the second physical page according to the first parameter of the first physical page in combination with a location relationship between the second physical page and the first physical page; and

storing the first parameter of the first physical page and the first parameter of the second physical page.

29. A storage medium storing executable instructions that, when executed, implement an operation method of claim 28.

**100**

Fig. 1

202

104

Memory
device

Memory
controller

106

204

# Fig.2A

206

104

| memory device | memory device | memory device |
| memory device | memory device | memory device |

memory controller

106

208

# Fig.2B

Fig. 3

**301**

Fig. 4

**300**

Voltage generator — 510

516 — 512 — 508 — 301

Control logic ⟷ row decoder/word line driver — Memory cell array

I/F

register — 514

page buffer/sense amplifier — 504

column decoder/bit line driver — 506

518

Fig.5

When performing a read scrub operation, obtain a first parameter of a first physical page of a plurality of physical pages, wherein the first parameter is a parameter in a preset model for generating a target reference voltage, and the target reference voltage is used as a read voltage of the physical page when performing a read operation, and wherein the plurality of physical pages includes the first physical page and a second physical page, the first physical page is a target physical page of the read scrub operation in the plurality of physical pages, and the second physical page is another physical page other than the first physical page of the plurality of physical pages ⟿ S10

Generate a first parameter of the second physical page according to the first parameter of the first physical page in combination with a location relationship between the second physical page and the first physical page ⟿ S20

Store the first parameter of the first physical page and the first parameter of the second physical page ⟿ S30

# Fig.6

Fig. 7A

Fig. 7B

Fig. 7C

Fig.8

Fig. 9

Fig. 10

Fig. 11

Fig. 12

Fig. 13

Fig.14

Fig. 15

Fig. 16

Fig. 17

Fig.18

S101

Start

load a relation table and a parameter table of a mapping
function between first parameters of physical pages
coupled to different word lines

S102

perform a read scrub operation

S103

whether the read
result is decoded
successfully?

S104

YES

NO

update the first parameter of the first physical page
according to the Nth updated parameter table

S106

generate the first parameter of the second physical
page according to the updated first parameter of the
first physical page

S107

store the updated first parameter of the first
physical page and the generated first parameter of
the second physical page for the (N+1)th time as
the (N+1)th updated parameter table

S108

End

S105

Fig.19

EP 4 712 080 A1

memory system
_____ 102

memory controller
_____ 106

Host

Host I/F ___1061

Control unit ___1063
CPU

ROM ___1069

RAM ___1070

Data buffer ___1067

_____ 1060

Error Correction Module (ECC) ___1064

Garbage Collection Module (GC) ___1065

Wear Leveling Module (WL) ___1066

Memory I/F ___1062

Memory device ___104

Fig.20

102

106

Memory controller

feedback data

read scrub start instruction

104

Memory device

# Fig. 21

Cycle Type
DQx

CMD
EFh

ADDR
DBh

Din

• • •

# Fig. 22

EP 4 712 080 A1

Cycle Type ⎯⟨CMD 00h⟩→⟨ADDR xxh⟩ ••• →⟨CMD 30h⟩→⟨Dout⟩ ••• ⟨CMD EFh⟩→⟨ADDR xxh⟩⟨Din⟩ ••• →⟨CMD EFh⟩→⟨ADDR xxh⟩⟨Din⟩ •••
DQx ⎯

→⟨CMD 00h⟩→⟨ADDR xxh⟩ ••• →⟨CMD 30h⟩→⟨Dout⟩ •••

# Fig. 23

S201

Start

S202

full-disk

S203

temperature change processing operation

S204

Power on

S205

perform a read scrub operation on the first physical page

S206

whether the read result is decoded successfully?

YES

NO

S208

perform a read operation on the second physical page

S207

End

Fig. 24

Fig. 25

## INTERNATIONAL SEARCH REPORT

| International application No. |
|---|
| **PCT/CN2024/107652** |

**A. CLASSIFICATION OF SUBJECT MATTER**

G11C 16/26(2006.01)i

According to International Patent Classification (IPC) or to both national classification and IPC

**B. FIELDS SEARCHED**

Minimum documentation searched (classification system followed by classification symbols)

IPC: G11C

Documentation searched other than minimum documentation to the extent that such documents are included in the fields searched

Electronic data base consulted during the international search (name of data base and, where practicable, search terms used)

CNABS, VEN, USTXT, WOTXT, EPTXT, CNTXT, IEEE, ISI, CNKI: 存储, 字线, 物理页, 页, 参数, 参考电压, 模型, 位置, 读取电压, 映射, 函数, 巡检, 更新, 曲率, 二次函数, 翻转, store, word line, physical page, page, parameter, reference voltage, model, location, read voltage, map, function, read scrub, update, curvature, quadratic function, flip

**C. DOCUMENTS CONSIDERED TO BE RELEVANT**

| Category* | Citation of document, with indication, where appropriate, of the relevant passages | Relevant to claim No. |
|---|---|---|
| X | CN 116778986 A (HARBIN INSTITUTE OF TECHNOLOGY) 19 September 2023 (2023-09-19) description, paragraphs 42-65 | 1-7, 15, 18-25, 28-29 |
| A | CN 114242136 A (GUANGDONG UNIVERSITY OF TECHNOLOGY) 25 March 2022 (2022-03-25) entire document | 1-29 |
| A | CN 118057284 A (YANGTZE MEMORY TECHNOLOGIES CO., LTD.) 21 May 2024 (2024-05-21) entire document | 1-29 |
| A | US 10490288 B1 (SEAGATE TECHNOLOGY LLC) 26 November 2019 (2019-11-26) entire document | 1-29 |
| A | US 2007070696 A1 (MSYSTEMS LTD.) 29 March 2007 (2007-03-29) entire document | 1-29 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **02 April 2025** | **09 April 2025** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| PCT/CN2024/107652 |

| Patent document<br>cited in search report | | | Publication date<br>(day/month/year) | Patent family member(s) | | | Publication date<br>(day/month/year) |
|---|---|---|---|---|---|---|---|
| CN | 116778986 | A | 19 September 2023 | None | | | |
| CN | 114242136 | A | 25 March 2022 | None | | | |
| CN | 118057284 | A | 21 May 2024 | None | | | |
| US | 10490288 | B1 | 26 November 2019 | None | | | |
| US | 2007070696 | A1 | 29 March 2007 | US | 7957189 | B2 | 07 June 2011 |
| | | | | US | 2011170349 | A1 | 14 July 2011 |
| | | | | US | 8665645 | B2 | 04 March 2014 |

Form PCT/ISA/210 (patent family annex) (July 2022)